# EUROPÄISCHE PATENTANMELDUNG

(11) **EP 3 296 787 A1**
(43) Veröffentlichungstag der Anmeldung: **21.03.2018**
(21) Anmeldenummer: 17182236.4
(22) Anmeldetag: 20.07.2017
(51) Int. Cl.: G02B 7/182, G03F 7/20

(54) **OPTISCHES MODUL MIT VERKIPPBAREN OPTISCHEN FLÄCHEN**

(30) Priorität: 14.09.2016 DE 102016217479
(71) Anmelder: Carl Zeiss SMT GmbH, 73447 Oberkochen (DE)
(72) Erfinder: Weber, Ulrich, 89075 Ulm (DE); Nefzi, Marwene, 89073 Ulm (DE)
(74) Vertreter: Carl Zeiss AG - Patentabteilung

(57) **Zusammenfassung**

Die vorliegende Erfindung betrifft ein optisches Modul, insbesondere einen Facettenspiegel, mit einer Trägereinheit (112) für eine optische Fläche und einer Stützstruktur (113), wobei die Trägereinheit (112) durch die Stützstruktur (113) abgestützt ist. Die Stützstruktur (113) weist eine Basiseinheit (114), eine erste Stützeinheit und eine von der ersten Stützeinheit (115) verschiedene zweite Stützeinheit (116) auf. Die erste Stützeinheit (115) ist zwischen der Basiseinheit (114) und der Trägereinheit (112) angeordnet und definiert eine erste Bewegungsebene und eine erste Kippachse der Trägereinheit (112), wobei die erste Kippachse senkrecht zu der ersten Bewegungsebene verläuft und die Trägereinheit (112) relativ zu der Basiseinheit (114) um die erste Kippachse verkippbar ist. Die zweite Stützeinheit (116) ist zwischen der Basiseinheit (114) und der Trägereinheit (112) angeordnet und definiert eine zweite Bewegungsebene und eine zweite Kippachse der Trägereinheit (112), wobei die zweite Kippachse senkrecht zu der zweiten Bewegungsebene verläuft, die Trägereinheit (112) relativ zu der Basiseinheit (114) um die zweite Kippachse verkippbar ist und die zweite Kippachse zu der ersten Kippachse geneigt verläuft. Die erste Stützeinheit (115) und die zweite Stützeinheit (116) sind zueinander kinematisch parallel zwischen der Basiseinheit (114) und der Trägereinheit (112) angeordnet, wobei die erste Stützeinheit (115) und die zweite Stützeinheit (116) jeweils nach Art eines Viergelenkgetriebes ausgebildet sind, das eine translatorische Bewegung der Trägereinheit (112) relativ zu der Basiseinheit (114) in der jeweiligen Bewegungsebene zulässt. Die erste Stützeinheit (115) und die zweite Stützeinheit (116) weisen jeweils wenigstens einen Entkopplungsabschnitt auf, der die translatorische Bewegung in der Bewegungsebene der jeweils anderen Stützeinheit (116, 115) zulässt.

## Beschreibung

### HINTERGRUND DER ERFINDUNG

Die vorliegende Erfindung betrifft ein optisches Modul, insbesondere einen Facettenspiegel mit einer oder mehreren verkippbaren optischen Flächen. Weiterhin betrifft die Erfindung eine optische Abbildungseinrichtung mit einem solchen optischen Modul, ein entsprechendes Verfahren zum Abstützen einer Trägereinrichtung einer optischen Fläche eines solchen optischen Moduls sowie ein entsprechendes optisches Abbildungsverfahren. Die Erfindung lässt sich im Zusammenhang mit beliebigen optischen Abbildungsverfahren einsetzen. Besonders vorteilhaft lässt sie sich bei der Herstellung oder der Inspektion mikroelektronischer Schaltkreise sowie der hierfür verwendeten optischen Komponenten (beispielsweise optischer Masken) einsetzen.

Optische Module der genannten Art, insbesondere Facettenspiegel, werden in der Halbleiterlithographie bei Arbeitswellenlängen im UV-Bereich (beispielsweise im Bereich von 193 nm), aber auch im so genannten extremen UV-Bereich (EUV) mit Arbeitswellenlängen zwischen 5 nm und 20 nm (typischerweise im Bereich von 13 nm), zur Herstellung mikro- bzw. nanostrukturierter Bauteile eingesetzt.

Dabei dienen die optischen Module dazu, eine möglichst homogene Ausleuchtung einer Masken- bzw. Retikelebene zu gewährleisten. Zudem werden mithilfe der optischen Module unterschiedliche Beleuchtungssettings (Beleuchtungswinkelverteilungen) im Bereich der Masken- bzw. Retikelebene realisiert. Die Anordnung und die Funktionsweise von optischen Modulen der hier in Rede stehenden Art, insbesondere Facettenspiegeln, in einer Projektionsbelichtungsanlage sind beispielsweise in der DE 100 53 587 A1 und der DE 10 2010 003 169 A1 beschrieben, deren gesamter Offenbarungsgehalt jeweils hierin durch Bezugnahme eingeschlossen wird.

Solche Facettenspiegel umfassen in der Regel eine Vielzahl von Facettenelementen mit einer oder mehreren reflektierenden optischen Flächen. Die Facettenelemente sind über eine Stützstruktur abgestützt und meist in mehreren Facettengruppen angeordnet. Dabei sind die Kippwinkel der einzelnen Facettenelemente bzw. ihrer optischen Flächen einzeln oder in Gruppen meist über eine entsprechende Aktuatorik der Stützstruktur einstellbar, um jeweils gewünschte Intensitätsverteilungen über das Beleuchtungslichtbündel bzw. unterschiedliche Beleuchtungssettings zu erzielen. Die das jeweilige Facettenelement abstützende Stützstruktur gibt dabei die Bewegungsbahn des einzelnen Facettenelements vor.

Derartige Facettenmodule sind beispielsweise aus der DE 10 2012 223 034 A1 bekannt, deren gesamter Offenbarungsgehalt hierin durch Bezugnahme eingeschlossen wird. Bei dieser Gestaltung wird ein Facettenelement durch ein Tripod aus dünnen Stützelementen abgestützt, deren Längsachsen sich in einem gemeinsamen Punkt schneiden. Hierdurch wird eine Abstützung realisiert, deren Kinematik letztlich einem Kugelgelenk entspricht, wobei durch den Schnittpunkt der Längsachsen der Stützelemente unendlich viele Kippachsen definiert sind. Problematisch ist hierbei zum einen die geringe Steifigkeit der dünnen Stützelemente. Diese führt einerseits zu einem hohen Knickrisiko der Stützelemente. Zum anderen ist diese Gestaltung sehr empfindlich gegen Verdrehungen in der Ebene der optischen Fläche. Beide Risiken sollen durch einen zylindrischen elastischen Balg reduziert werden, der das Tripod umgibt. Problematisch herbei ist jedoch nicht zuletzt die große Streuung der mechanischen Eigenschaften solcher Bälge, sodass sich die präzise Abstimmung der Gestaltung höchst schwierig gestaltet. Ein weiteres Problem dieser Gestaltung liegt in der geringen Wärmeabfuhr durch die dünnen Stützelemente mit ihren geringen Wärmedurchgangsquerschnitten.

Eine andere Gestaltung eines solchen Facettenmoduls ist beispielsweise aus der DE 10 2014 214 288 A1 bekannt, deren gesamter Offenbarungsgehalt hierin durch Bezugnahme eingeschlossen wird. Bei dieser Gestaltung werden zwei orthogonale Kippachsen der optischen Fläche durch zwei ineinander verschachtelte, separat hergestellte Stützeinheiten definiert. Die jeweilige Kippachse wird dabei durch eine Vielzahl von ebenen Blattfedern bestimmt, deren Federebenen sich alle in der betreffenden Kippachse schneiden. Die beiden Stützeinheiten sind dabei kinematisch seriell (also in Richtung des Kraftflusses hintereinander) zwischen einer Basiseinheit und der Trägereinheit des Facettenelements angeordnet. Diese Gestaltung mit Blattfedern ist dabei wegen des insgesamt vergleichsweise großen Wärmedurchgangsquerschnitts der Blattfedern grundsätzlich von Vorteil. Weiterhin sperren die Blattfedern zwar die Rotation in der Ebene der optischen Fläche. Unter thermischen Gesichtspunkten ergibt sich durch die serielle Anordnung der Stützeinheiten jedoch ein langer Wärmeleitweg, wodurch sich der Wärmewiderstand der Stützeinheiten erhöht und der Vorteil des erhöhten Wärmedurchgangsquerschnitts wieder teilweise zunichtegemacht wird. Auch unter dynamischen Aspekten ist die serielle Anordnung der verschachtelten Stützeinheiten problematisch. So erfordert sie eine komplexe Abstimmung der Eigenfrequenzen der beiden Stützeinheiten, um ein homogenes dynamisches Verhalten um beide Kippachsen zu erzielen.

Beiden vorgenannten Lösungen gemeinsam ist das Aktuierungsprinzip über einen zentralen Kipphebel, der mit der Rückseite des Facettenelements verbunden ist und typischerweise berührungslos (z. B. durch entsprechende elektromagnetische Felder) bewegt wird. Nachteilig ist hierbei, dass diese Art der Aktuierung zum einen parasitäre Querkräfte erzeugt, die eine der Verkippung überlagerte parasitäre Translation der Facette bewirken. Zudem ist die Position des Kipphebels im unbestromten Zustand nicht präzise definiert, sodass es bei Inbetriebnahme zu Überschwingeffekten kommen kann.

### KURZE ZUSAMMENFASSUNG DER ERFINDUNG

Ausgehend von dem voranstehend beschrieben Stand der Technik liegt der Erfindung die Aufgabe zugrunde, ein optisches Modul, eine optische Abbildungseinrichtung, ein Verfahren zum Abstützen einer Trägereinheit für eine optische Fläche sowie ein Abbildungsverfahren zur Verfügung zu stellen, welches bzw. welche die zuvor genannten Nachteile nicht oder zumindest in geringerem Maße aufweist und insbesondere auf einfache Weise eine unter dynamischen und thermischen Aspekten verbesserte Abstützung der optischen Fläche zu realisieren.

Der Erfindung liegt die technische Lehre zugrunde, dass bei einem optischen Modul der eingangs genannten Art auf einfache Weise eine unter dynamischen und thermischen Aspekten verbesserte Abstützung der optischen Fläche erzielen kann, indem man zur Abstützung der Trägereinheit eine Parallelkinematik aus zwei separaten Stützeinheiten verwendet, die jeweils nach Art eines Viergelenkgetriebes ausgebildet sind, das neben der Verkippung um die Kippachse eine translatorische Bewegung der Trägereinheit relativ zu der Basiseinheit in der jeweiligen Bewegungsebene zulässt, wobei jede Stützeinheit dann wenigstens einen Entkopplungsabschnitt aufweist, der die translatorische Bewegung in der Bewegungsebene der anderen Stützeinheit zulässt.

Die Parallelkinematik ist dabei insoweit von Vorteil als sie eine nahezu identische Gestaltung der Komponenten der Stützeinheiten ermöglicht und sich hierdurch die Anpassung der Eigenfrequenzen um beide Kippachsen vereinfacht bzw. gegebenenfalls von selbst ergibt. Zudem verkürzt sich durch die Parallelkinematik der Wärmeleitweg durch die Stützstruktur (gegenüber einer seriellen Kinematik), sodass deren thermischer Widerstand in vorteilhafter Weise sinkt.

Dank der Entkopplungsabschnitte ist es möglich, das Viergelenkgetriebe unter Verwendung von Gelenken zu realisieren, die einen Rotationsfreiheitsgrad um eine Rotationsachse einschränken, die in der zugehörigen Bewegungsebene des Viergelenkgetriebes liegt. Mithin ist es also möglich, konventionelle Scharniergelenke oder dergleichen zu verwenden, die beispielsweise als einfache Festkörpergelenke gestaltet sein können und/oder einen vergleichsweise großen Wärmedurchgangsquerschnitt aufweisen können. Dies ist nicht nur unter thermischen Gesichtspunkten von Vorteil, sondern ermöglicht auch eine vergleichsweise steife Konfiguration, die auch unter dynamischen Aspekten vorteilhaft ist. Gleiche bzw. ähnliche Gelenke können auch für die Entkopplungsabschnitte verwendet werden, sodass insgesamt eine unter thermischen und dynamischen Aspekten vorteilhafte Stützstruktur realisiert werden kann.

Zudem ist es in der Regel möglich, eine derartige Parallelkinematik monolithisch zu fertigen, wodurch sich die thermischen und dynamischen Eigenschaften der Abstützung weiter verbessern.

Ein besonderer Vorteil des jeweiligen Viergelenkgetriebes liegt weiterhin darin, dass es in einfacher Weise eine Abkehr von der Aktuierung durch den zentralen Kipphebel der bekannten Gestaltungen ermöglicht. Während eine solche zentrale Aktuierung, sofern gewünscht, nach wie vor realisierbar ist, kann die Aktuatorik in vorteilhafter Weise aber auch an den Komponenten des Viergelenkgetriebes angreifen. Hierdurch erhöht sich die Flexibilität der Gestaltung erheblich.

Ein weiterer Vorteil der erfindungsgemäßen Gestaltung besteht darin, dass die beiden Stützeinheiten ohne weitere Zusatzmaßnahmen einen Rotationsfreiheitsgrad um eine Rotationsachse einschränken können, die senkrecht zu einer Ebene verläuft, die durch die beiden Kippachsen der Stützeinheiten aufgespannt wird bzw. parallel zu beiden Kippachsen verläuft. Mithin kann auf einfache Weise insbesondere eine Verdrehung in der Ebene der optischen Fläche verhindert werden, ohne dass zusätzliche Hilfseinrichtungen (wie beispielsweise der aus der DE 10 2012 223 034 A1 bekannte zylindrische Balg) erforderlich sind.

Nach einem Aspekt betrifft die Erfindung daher ein optisches Modul, insbesondere Facettenspiegel, mit einer Trägereinheit für eine optische Fläche und einer Stützstruktur, wobei die Trägereinheit durch die Stützstruktur abgestützt ist. Die Stützstruktur weist eine Basiseinheit, eine erste Stützeinheit und eine von der ersten Stützeinheit verschiedene zweite Stützeinheit auf. Die erste Stützeinheit ist zwischen der Basiseinheit und der Trägereinheit angeordnet und definiert eine erste Bewegungsebene und eine erste Kippachse der Trägereinheit, wobei die erste Kippachse senkrecht zu der ersten Bewegungsebene verläuft und die Trägereinheit relativ zu der Basiseinheit um die erste Kippachse verkippbar ist. Die zweite Stützeinheit ist zwischen der Basiseinheit und der Trägereinheit angeordnet und definiert eine zweite Bewegungsebene und eine zweite Kippachse der Trägereinheit, wobei die zweite Kippachse senkrecht zu der zweiten Bewegungsebene verläuft, die Trägereinheit relativ zu der Basiseinheit um die zweite Kippachse verkippbar ist und die zweite Kippachse zu der ersten Kippachse geneigt verläuft. Die erste Stützeinheit und die zweite Stützeinheit sind zueinander kinematisch parallel zwischen der Basiseinheit und der Trägereinheit angeordnet, wobei die erste Stützeinheit und die zweite Stützeinheit jeweils nach Art eines Viergelenkgetriebes ausgebildet sind, das eine translatorische Bewegung der Trägereinheit relativ zu der Basiseinheit in der jeweiligen Bewegungsebene zulässt. Die erste Stützeinheit und die zweite Stützeinheit weisen jeweils wenigstens einen Entkopplungsabschnitt auf, der die translatorische Bewegung in der Bewegungsebene der jeweils anderen Stützeinheit zulässt.

Es sei an dieser Stelle angemerkt, dass unter zwei separaten Stützeinheiten im Sinne der vorliegenden Erfindung zwei Stützeinheiten verstanden werden sollen, die keine gemeinsamen Komponenten aufweisen, mithin also vollständig voneinander getrennt sind im Bereich der Basiseinheit bzw. der Trägereinheit an einer gemeinsamen Struktur angreifen. Durch zwei derartige separate Stützeinheiten wird unter anderem der Wärmedurchgangsquerschnitt der Stützstruktur erhöht, was unter thermischen Gesichtspunkten von Vorteil ist.

Die Stützeinheiten können grundsätzlich beliebig gestaltet sein, um die gewünschte Parallelkinematik mit den Viergelenkgetrieben zu realisieren. Dabei können die beiden Stützeinheiten grundsätzlich eine beliebige geeignete Gestaltung aufweisen. Insbesondere kann für beide Stützeinheiten eine voneinander abweichende Gestaltung vorgesehen sein.

Bei besonders vorteilhaften, weil einfach gestalteten Varianten sind die erste Stützeinheit und die zweite Stützeinheit jeweils nach Art eines Bipods ausgebildet, wobei sie einen ersten Schenkelabschnitt und einen zweiten Schenkelabschnitt aufweisen. Dabei kann vorgesehen sein, dass wenigstens eine der beiden Stützeinheiten eine Bipodebene definiert, die mit der zugehörigen Bewegungsebene zusammenfällt. Zusätzlich oder alternativ können die erste Stützeinheit und die zweite Stützeinheit derart ineinander verschachtelt angeordnet sein, dass eine Schnittlinie der beiden Bewegungsebenen jeweils zwischen den beiden Schenkelabschnitten liegt. In beiden Fällen ergeben sich besonders einfache und kompakte Gestaltungen, wie sie insbesondere für Facetten Spiegel mit einer Vielzahl dicht aneinander gepackter Facettenelemente von Vorteil sind.

Bei weiteren Varianten kann vorgesehen sein, dass die erste Stützeinheit und die zweite Stützeinheit derart angeordnet sind, dass sie um eine Schnittlinie der beiden Bewegungsebenen zueinander verdreht angeordnet sind. Hierdurch können in einfacher Weise Gestaltungen erzielt werden, bei denen die Freiheitsgrade quer zu Bewegungsebene der einen Stützeinheit durch die andere Stützeinheit eingeschränkt sind, sodass sich in einfacher Weise eine stabile Stützkonfiguration ergibt. Der Verdrehwinkel kann grundsätzlich beliebig gewählt sein. Besonders günstige und einfach zu realisierende Konfigurationen ergeben sich, wenn die beiden Stützeinheiten zueinander um einen Winkel von 60° bis 90°, vorzugsweise 75° bis 90°, weiter vorzugsweise 80° bis 90°, verdreht angeordnet sind. Speziell bei einem Verdrehwinkel von 90° ergeben sich besonders einfache Gestaltungen mit klar definierten bzw. einfach auszulegenden mechanischen, insbesondere dynamischen Eigenschaften.

Wie bereits erwähnt, können die beiden Stützeinheiten grundsätzlich voneinander verschieden gestaltet sein. Besonders vorteilhafte und hinsichtlich ihrer mechanischen Eigenschaften besonders einfach auszulegende Konfigurationen ergeben sich, wenn die erste Stützeinheit und die zweite Stützeinheit im Wesentlichen identisch gestaltet sind. Hierbei ist es insbesondere von Vorteil, die beiden Stützeinheiten mit Ausnahme eines die jeweiligen Schenkelabschnitte trägerseitig verbindenden Brückenabschnitts identisch zu gestalten. Lediglich die beiden Brückenabschnitte können dann abweichend (insbesondere komplementär) gestaltet sein, um das Durchdringen der Bauräume der beiden Stützeinheiten bei einer ineinander verschachtelten Anordnung der beiden Stützeinheiten zu realisieren.

Bei bestimmten Varianten kann vorgesehen sein, dass die erste Stützeinheit und die zweite Stützeinheit derart gestaltet sind, dass sie einen Rotationsfreiheitsgrad um eine Rotationsachse einschränken, die senkrecht zu einer Ebene verläuft, die durch die erste Kippachse und die zweite Kippachse aufgespannt wird oder parallel zu der ersten Kippachse und der zweiten Kippachse verläuft. Hiermit kann auf einfache Weise die oben erwähnte Verdrehung in der Ebene der optischen Fläche verhindert werden, ohne dass zusätzliche Hilfseinrichtungen erforderlich sind.

Die Gestaltung des Viergelenkgetriebes kann grundsätzlich beliebig gewählt sein, solange die Kippachse senkrecht zur Bewegungsebene sowie die Translation in der Bewegungsebene realisiert sind. Bei bevorzugten Varianten weisen die erste Stützeinheit und die zweite Stützeinheit jeweils zwei voneinander beabstandete trägerseitige Gelenkabschnitte und zwei voneinander beabstandete basisseitige Gelenkabschnitte auf, womit sich eine besonders einfache Gestaltung ergibt.

Hierbei kann vorgesehen sein, dass wenigstens einer der Gelenkabschnitte, vorzugsweise jeder der Gelenkabschnitte, eine Gelenkachse für eine rotatorische Gelenkbewegung definiert, wobei die Gelenkachse zumindest im Wesentlichen parallel zu der Kippachse der zugehörigen Stützeinheit ist. Zusätzlich oder alternativ können die Gelenkabschnitte wenigstens einer der beiden Stützeinheiten derart angeordnet und ausgebildet sein, dass ein ebenes Viergelenkgetriebe ausgebildet ist. Zusätzlich oder alternativ können die Gelenkabschnitte wenigstens einer der beiden Stützeinheiten derart angeordnet und ausgebildet sein, dass sie in einem Betriebszustand die Eckpunkte eines Trapezes bilden. In allen diesen Fällen ergibt sich jeweils in vorteilhafter Weise eine besonders einfache und klar definierte Kinematik.

Die Gelenkabschnitte können grundsätzlich in beliebiger geeigneter Weise gestaltet sein. So kann wenigstens einer der Gelenkabschnitte, vorzugsweise jeder der Gelenkabschnitte, einen Rotationsfreiheitsgrad um eine Rotationsachse einschränken, die in der zugehörigen Bewegungsebene liegt. Hiermit ist es möglich, besonders einfache Gelenke zu realisieren, die vorteilhafter Weise einen vergleichsweise großen Wärmedurchgangsquerschnitt aufweisen.

Besonders günstig ist es, wenn wenigstens einer der Gelenkabschnitte, vorzugsweise jeder der Gelenkabschnitte, als Festkörpergelenk ausgebildet ist. Zusätzlich oder alternativ kann wenigstens einer der Gelenkabschnitte, vorzugsweise jeder der Gelenkabschnitte, als Biegegelenk ausgebildet sein. Insbesondere können einfache Scharniergelenke verwendet werden. Ebenso kann wenigstens einer der Gelenkabschnitte, vorzugsweise jeder der Gelenkabschnitte, von einem Blattfederelement gebildet sein. Besonders einfach herzustellende Gestaltungen ergeben sich, wenn wenigstens einer der trägerseitigen Gelenkabschnitte und einer der basisseitigen Gelenkabschnitte gemeinsam von einem Blattfederelement gebildet sind.

Bei bevorzugten Varianten umfasst wenigstens eine der beiden Stützeinheiten einen ersten Schenkelabschnitt und einen zweiten Schenkelabschnitt, wobei wenigstens ein Schenkelteil des ersten Schenkelabschnitts zwischen einem ersten basisseitigen Gelenkabschnitt und einem in Kraftflussrichtung nächstliegenden ersten trägerseitigen Gelenkabschnitt verläuft und in der zugehörigen Bewegungsebene eine erste Schenkellängsachse definiert, während wenigstens ein Schenkelteil des zweiten Schenkelabschnitts zwischen einem zweiten trägerseitigen Gelenkabschnitt und einem in Kraftflussrichtung nächstliegenden zweiten basisseitigen Gelenkabschnitt verläuft und in der zugehörigen Bewegungsebene eine zweite Schenkellängsachse definiert.

Durch die Wahl der Lage der Schenkellängsachsen lässt sich dann beispielsweise besonders einfach der Verlauf der jeweiligen Kippachse definieren. So können die erste Schenkellängsachse und die zweite Schenkellängsachse zueinander geneigt verlaufen. Insbesondere können die erste Schenkellängsachse und die zweite Schenkellängsachse einander in der zugehörigen Kippachse ihrer Stützeinheit schneiden.

Dabei können je nach der gewünschten Lage der Kippachse entsprechende Abstände zwischen den trägerseitigen und den basisseitigen Gelenkabschnitten gewählt sein. Vorzugsweise ist in der zugehörigen Bewegungsebene ein Abstand der beiden trägerseitigen Gelenkabschnitte geringer ist als ein Abstand der beiden basisseitigen Gelenkabschnitte. Hierdurch wird erreicht, dass die Kippachse trägerseitig des Viergelenkgetriebes angeordnet ist.

Bei weiteren Varianten umfasst wenigstens einer der beiden Schenkelteile ein Blattfederelement, insbesondere kann der Schenkelteil im Wesentlichen vollständig von einem Blattfederelement gebildet sein. Hierdurch ergibt sich eine besonders einfache Gestaltung, bei der die beiden Gelenkabschnitte in guter Näherung an den beiden Enden des Blattfederelements angenommen werden können.

Die Kippachse der jeweiligen Stützeinheit kann grundsätzlich beliebig entsprechend den Vorgaben der Abbildungseinrichtung gewählt sein. Insbesondere ist es möglich, die beiden gewachsen der beiden Stützeinheiten in unterschiedlichen Ebenen anzuordnen. Typischerweise sind die beiden Kippachsen jedoch in einer gemeinsamen Ebene angeordnet.

Bei bestimmten Varianten ist wenigstens eine der beiden Kippachsen auf einer der Basiseinheit zugewandten Seite der optischen Fläche angeordnet. Hiermit ist es möglich, durch geeignete Wahl der Abstände zwischen der optischen Fläche und der Kippachse eine Kompensation für die Translation der optischen Fläche in der Bewegungsebene zu erzielen, welche beim Verkippen in der Bewegungsebene mittels des Viergelenkgetriebes stattfindet.

Hierbei weist die optische Fläche in der zugehörigen Bewegungsebene typischerweise eine Flächennormale auf, welche durch die wenigstens eine Kippachse verläuft und ein erster Flächenpunkt der optischen Fläche weist auf der Flächennormalen einen Kippachsenabstand zu der wenigstens einen Kippachse auf, wobei sich der erste Flächenpunkt in einem ersten Betriebszustand in einer Referenzposition zu der Basiseinheit befindet. In diesen Fällen kann der Kippachsenabstand derart gewählt sein, dass sich ein zweiter Flächenpunkt der optischen Fläche in einem zweiten Betriebszustand an der Referenzposition befindet, wobei die optische Fläche in dem zweiten Betriebszustand gegenüber dem ersten Betriebszustand um die wenigstens eine Kippachse verkippt ist. Mit anderen Worten ist es möglich, eine Konfiguration zu erzielen, bei der die durch das Viergelenkgetriebe bedingte Translationsbewegung der optischen Fläche während des Verkippens um die Kippachse kompensiert wird, sodass das Licht an der Referenzposition in den beiden Betriebszuständen jeweils auf die optische Fläche trifft. Je nach Gestaltung der optischen Fläche werden dabei unterschiedliche Einfallswinkel des Lichts auf die optische Fläche realisiert. Gegebenenfalls kann in Spezialfällen aber auch vorgesehen sein, dass die optische Fläche so gestaltet ist, dass der Einfallswinkel des Lichts in den beiden Betriebszuständen im Wesentlichen derselbe ist.

Die in der einen Stützeinheiten realisierte Entkopplung translatorischen Bewegung in der Bewegungsebene der anderen Stützeinheit kann grundsätzlich auf beliebige geeignete Weise durch einen oder mehrere Entkopplungsabschnitte erfolgen. Der wenigstens eine Entkopplungsabschnitt kann dabei grundsätzlich auf beliebige geeignete Weise gestaltet und an beliebiger geeigneter Stelle angeordnet sein. Insbesondere ist es möglich, einen solchen Entkopplungsabschnitt innerhalb des Viergelenkgetriebes zu integrieren, beispielsweise kinematisch seriell zwischen den basisseitigen und den trägerseitigen Gelenkabschnitten anzuordnen. Bei bestimmten Varianten weisen die erste Stützeinheit und die zweite Stützeinheit jeweils einen das Viergelenkgetriebe ausbildenden Viergelenkgetriebeabschnitt auf. Hier kann dann vorgesehen sein, dass der wenigstens eine Entkopplungsabschnitt wenigstens einer der beiden Stützeinheiten kinematisch seriell zwischen dem Viergelenkgetriebeabschnitt und der Basiseinheit oder der Trägereinheit angeordnet ist. Hierdurch ergibt sich eine besonders einfache Konfiguration mit klar verteilten Rollen hinsichtlich der Kinematik der unterschiedlichen Abschnitte.

Bei bestimmten Varianten mit mehreren Entkopplungsabschnitten weist wenigstens eine der beiden Stützeinheiten einen ersten Entkopplungsabschnitt und einen zweiten Entkopplungsabschnitt auf, wobei der Viergelenkgetriebeabschnitt kinematisch seriell zwischen dem ersten Entkopplungsabschnitt und dem zweiten Entkopplungsabschnitt angeordnet ist.

Bei weiteren Varianten kann der wenigstens eine Entkopplungsabschnitt wenigstens einer der beiden Stützeinheit einen ersten Enkopplungsgelenkabschnitt, der eine erste Enkopplungsschwenkachse definiert, und einen zweiten Enkopplungsgelenkabschnitt aufweisen, der eine zweite Enkopplungsschwenkachse definiert, die zu der ersten Enkopplungsschwenkachse beabstandet und parallel ist. Hierdurch ist eine besonders einfache Entkopplung von Translationsbewegungen in der Bewegungsebene möglich. Besonders einfach gestaltet sich die Kinematik der Konfiguration dann, wenn die beiden Enkopplungsschwenkachsen parallel zu der Bewegungsebene der wenigstens einen Stützeinheit verlaufen.

Wie schon bei dem Viergelenkgetriebe können auch die Gelenke des jeweiligen Entkopplungsabschnitts auf beliebige geeignete Weise gestaltet sein, wobei insbesondere die oben angestellten Überlegungen zu den Gelenkabschnitten auch hier zutreffen. Vorzugsweise umfasst daher der wenigstens eine Entkopplungsabschnitt, vorzugsweise jeder Entkopplungsabschnitt, ein Festkörpergelenk. Zusätzlich oder alternativ kann der wenigstens eine Entkopplungsabschnitt, vorzugsweise jeder Entkopplungsabschnitt, wiederum ein Biegegelenk umfassen. Zusätzlich oder alternativ kann der wenigstens eine Entkopplungsabschnitt, vorzugsweise jeder Entkopplungsabschnitt, wiederum von einem Blattfederelement gebildet sein. Hiermit lassen sich auch im Bereich der Entkopplungsabschnitte die oben im Zusammenhang mit den Gelenkabschnitten des Viergelenkgetriebes geschilderten Vorteile erzielen.

Wie bereits eingangs ausgeführt wurde, kann die Verstellung der optischen Fläche auf vielfältige Weise realisiert sein. Dabei können grundsätzlich sowohl passive als auch aktive Verstellungsmechanismen realisiert werden. Bei vorteilhaften Varianten ist wenigstens ein Aktuatorelement zum Verkippen der Trägereinheit um wenigstens eine der beiden Kippachsen vorgesehen.

Das wenigstens eine Aktuatorelement kann direkt mit der Trägereinheit verbunden und dazu ausgebildet sein, kinematisch parallel zu der ersten Stützeinheit und der zweiten Stützeinheit zwischen der Trägereinheit und einer mit der Basiseinheit verbundenen aktiven Aktuatoreinheit zu wirken. Mithin kann also beispielsweise ähnlich wie bei den eingangs genannten bekannten Gestaltungen eine zentrale Aktuierung über einen zentralen Kipphebel erfolgen. Hierbei kann wobei das Aktuatorelement eine Längsachse definieren, die zumindest in einem Betriebszustand im Wesentlichen parallel, insbesondere im Wesentlichen kollinear, zu einer Schnittlinie der beiden Bewegungsebenen verläuft, wodurch sich eine besonders kompakte Gestaltung ergibt.

Bei weiteren Varianten kann die Verstelleinrichtung zusätzlich oder alternativ auch mit den Stützeinheiten zusammenwirken. Dabei kann die Verstelleinrichtung zwischen der Basiseinheit und/oder der Trägereinheit und der jeweiligen Stützeinheit wirken. Ebenso kann die Verstelleinrichtung auch vollständig innerhalb der jeweiligen Stützeinheit werden, beispielsweise zwischen zwei gelenkig miteinander verbundenen Komponenten der Stützeinheit. Bei bestimmten Varianten ist daher das wenigstens eine Aktuatorelement direkt mit einer der beiden Stützeinheiten verbunden und dazu ausgebildet, mit einer aktiven Aktuatoreinheit zusammenzuwirken, die innerhalb der Stützeinheit oder zwischen der Stützeinheit und der Basiseinheit oder zwischen der Stützeinheit und der Trägereinheit wirkt.

Bei bestimmten besonders einfach gestalteten Varianten ist die erste Stützeinheit und/oder die zweite Stützeinheit nach Art eines Bipods ausgebildet, das einen ersten Schenkelabschnitt und einen zweiten Schenkelabschnitt umfasst, die einen das Viergelenkgetriebe ausbildenden Viergelenkgetriebeabschnitt aufweisen, wobei das wenigstens eine Aktuatorelement direkt mit einem Aktuatorabschnitt eines der beiden Schenkelabschnitte verbunden ist und der Aktuatorabschnitt kinematisch seriell zu dem Viergelenkgetriebeabschnitt zwischen der Basiseinheit und der Trägereinheit angeordnet ist.

Das Aktuatorelement kann dann dazu ausgebildet sein, mit der aktiven Aktuatoreinheit zusammenzuwirken, um den Aktuatorabschnitt in der Bewegungsebene der zugehörigen Stützeinheit zu verschwenken. Hiermit lässt sich eine besonders einfache Kinematik realisieren.

Die Lage und Anbindung des Aktuatorabschnitts kann grundsätzlich auf beliebige geeignete Weise gewählt sein. Bei vorteilhaften, weil einfach gestalteten Varianten kann der Aktuatorabschnitt über eine Verbindungsgelenkeinheit mit der Basiseinheit oder der Trägereinheit verbunden sein, wobei die Verbindungsgelenkeinheit eine Verbindungsschwenkachse definiert, die quer, insbesondere senkrecht, zu der Bewegungsebene der zugehörigen Stützeinheit verläuft. Die Verbindungsgelenkeinheit kann grundsätzlich wiederum in beliebiger geeigneter Weise gestaltet sein. Insbesondere kann sie identisch oder ähnlich zu den oben bereits beschriebenen Gelenkabschnitten des Viergelenkgetriebes bzw. der Entkopplungsabschnitte ausgeführt sein. Bei besonders einfach gestalteten Varianten umfasst die Verbindungsgelenkeinheit wiederum wenigstens ein Blattfederelement.

Die jeweilige Stützeinheit kann grundsätzlich auf beliebige geeignete Weise gestaltet sein. Insbesondere kann sie aus mehreren separat gefertigten Komponenten zusammengesetzt sein. Bei besonders günstigen Varianten ist zumindest die erste Stützeinheit und/oder die zweite Stützeinheit zumindest abschnittsweise monolithisch ausgebildet, da dies unter dynamischen und thermischen Aspekten besonders günstig ist.

Zusätzlich oder alternativ kann die erste Stützeinheit und/oder die zweite Stützeinheit nach Art eines Bipods ausgebildet sein, das einen ersten Schenkelabschnitt und einen zweiten Schenkelabschnitt umfasst, die einen das Viergelenkgetriebe ausbildenden Viergelenkgetriebeabschnitt aufweisen, wobei der erste Schenkelabschnitt und/oder der zweite Schenkelabschnitt monolithisch ausgebildet ist. Dabei kann insbesondere der Viergelenkgetriebeabschnitt monolithisch ausgebildet sein. Zusätzlich oder alternativ kann der erste Schenkelabschnitt monolithisch mit dem zweiten Schenkelabschnitt ausgebildet sein.

Bei weiteren thermisch und dynamisch vorteilhaften Varianten ist die erste Stützeinheit und/oder die zweite Stützeinheit monolithisch mit der Trägereinheit und/oder der Basiseinheit verbunden.

Es versteht sich, dass die optische Fläche bereits direkt an der Trägereinheit ausgebildet sein kann. Bei weiteren Varianten ist ein die optische Fläche aufweisender optischer Elementkörper mit der Trägereinheit verbunden. Bei bestimmten Varianten trägt die Trägereinheit ein optisches Element, insbesondere ein Facettenelement, an dem die optische Fläche ausgebildet ist.

Die vorliegende Erfindung lässt sich grundsätzlich für ein einzelnes optisches Element mit einer einzelnen optischen Fläche verwenden. Vorzugsweise findet sie im Zusammenhang mit optischen Modulen Anwendungen, bei denen mehrere solcher optischen Flächen separat voneinander gelagert und verstellt werden sollen. Bei bestimmten Varianten bilden die erste Stützeinheit, die zweite Stützeinheit und die Trägereinheit daher ein Teilmodul und es ist eine Mehrzahl dieser Teilmodule in dem optischen Modul vorgesehen. Dabei kann jedes Teilmodul eine eigene Basiseinheit umfassen, die mit einer Basisstruktur des optischen Moduls verbunden ist. Ebenso kann für mehrere (gegebenenfalls alle) Teilmodule eine gemeinsame Basiseinheit vorgesehen sein.

Die vorliegende Erfindung betrifft weiterhin eine optische Abbildungseinrichtung, insbesondere für die Mikrolithographie, mit einer Beleuchtungseinrichtung mit einer ersten optischen Elementgruppe, einer Objekteinrichtung zur Aufnahme eines Objekts, einer Projektionseinrichtung mit einer zweiten optischen Elementgruppe und einer Bildeinrichtung, wobei die Beleuchtungseinrichtung zur Beleuchtung des Objekts ausgebildet ist und die Projektionseinrichtung zur Projektion einer Abbildung des Objekts auf die Bildeinrichtung ausgebildet ist. Die Beleuchtungseinrichtung und/oder die Projektionseinrichtung umfasst wenigstens ein erfindungsgemäßes optisches Modul. Auch hiermit lassen sich die oben im Zusammenhang mit dem erfindungsgemäßen optischen Modul beschriebenen Varianten und Vorteile in demselben Maße erreichen, sodass insoweit auf die obigen Ausführungen Bezug genommen wird.

Die vorliegende Erfindung betrifft weiterhin ein Verfahren zum Abstützen einer Trägereinheit für eine optische Fläche eines optischen Moduls, insbesondere eines Facettenspiegels, bei dem die Trägereinheit durch die Stützstruktur abgestützt wird, wobei die Stützstruktur eine Basiseinheit, eine erste Stützeinheit und eine von der ersten Stützeinheit verschiedene zweite Stützeinheit aufweist. Die erste Stützeinheit wird zwischen der Basiseinheit und der Trägereinheit angeordnet, wobei sie eine erste Bewegungsebene und eine erste Kippachse der Trägereinheit definiert, wobei die erste Kippachse senkrecht zu der ersten Bewegungsebene verläuft und die Trägereinheit relativ zu der Basiseinheit um die erste Kippachse verkippbar ist. Die zweite Stützeinheit wird zwischen der Basiseinheit und der Trägereinheit angeordnet wird, wobei sie eine zweite Bewegungsebene und eine zweite Kippachse der Trägereinheit definiert, wobei die zweite Kippachse senkrecht zu der zweiten Bewegungsebene verläuft, die Trägereinheit relativ zu der Basiseinheit um die zweite Kippachse verkippbar ist und die zweite Kippachse zu der ersten Kippachse geneigt verläuft. Die erste Stützeinheit und die zweite Stützeinheit werden zueinander kinematisch parallel zwischen der Basiseinheit und der Trägereinheit angeordnet, wobei die erste Stützeinheit und die zweite Stützeinheit jeweils nach Art eines Viergelenkgetriebes ausgebildet werden, das eine translatorische Bewegung der Trägereinheit relativ zu der Basiseinheit in der jeweiligen Bewegungsebene zulässt. Die die erste Stützeinheit und die zweite Stützeinheit werden jeweils mit wenigstens einen Entkopplungsabschnitt versehen, der die translatorische Bewegung in der Bewegungsebene der jeweils anderen Stützeinheit zulässt. Auch hiermit lassen sich die oben im Zusammenhang mit dem erfindungsgemäßen optischen Modul beschriebenen Varianten und Vorteile in demselben Maße erreichen, sodass insoweit auf die obigen Ausführungen Bezug genommen wird.

Die vorliegende Erfindung betrifft weiterhin ein optisches Abbildungsverfahren, insbesondere für die Mikrolithographie, bei dem über eine Beleuchtungseinrichtung mit einer ersten optischen Elementgruppe ein Objekt beleuchtet wird und mittels einer Projektionseinrichtung mit einer zweiten optischen Elementgruppe eine Abbildung des Objekts auf einer Bildeinrichtung erzeugt wird. Dabei wird in der Beleuchtungseinrichtung und/der Projektionseinrichtung, insbesondere während des Erzeugens der Abbildung, ein erfindungsgemäßes Verfahren zum Abstützen einer Trägereinheit für eine optische Fläche eines optischen Moduls verwendet. Auch hiermit lassen sich die oben im Zusammenhang mit dem erfindungsgemäßen optischen Modul beschriebenen Varianten und Vorteile in demselben Maße erreichen, sodass insoweit auf die obigen Ausführungen Bezug genommen wird.

Weitere Aspekte und Ausführungsbeispiele der Erfindung ergeben sich aus den abhängigen Ansprüchen und der nachfolgenden Beschreibung bevorzugter Ausführungsbeispiele, die sich auf die beigefügten Figuren bezieht. Alle Kombinationen der offenbarten Merkmale, unabhängig davon, ob diese Gegenstand eines Anspruchs sind oder nicht, liegen im Schutzbereich der Erfindung.

### KURZE BESCHREIBUNG DER ZEICHNUNGEN

- Figur 1: ist eine schematische Darstellung einer bevorzugten Ausführung einer erfindungsgemäßen Projektionsbelichtungsanlage, die eine bevorzugte Ausführung eines erfindungsgemäßen optisches Moduls umfasst und mit der bevorzugte Ausführungen der erfindungsgemäßen Verfahren ausgeführt werden können.
- Figur 2: ist eine schematische perspektivische Darstellung eines ersten Ausführungsbeispiels eines erfindungsgemäßen optischen Moduls aus Figur 1.
- Figur 3: ist eine schematische perspektivische Ansicht eines Details des optischen Moduls aus Figur 2 (Detail III).
- Figur 4: ist ein mechanisches Ersatzschaltbild der Schnittansicht des optischen Moduls aus Figur 3 entlang der Linie IV-IV in einem ersten Betriebszustand.
- Figur 5: ist ein mechanisches Ersatzschaltbild der Schnittansicht des optischen Moduls aus Figur 3 entlang der Linie V-V in dem ersten Betriebszustand.
- Figur 6: ist ein mechanisches Ersatzschaltbild des optischen Moduls aus Figur 5 in einem zweiten Betriebszustand.

### DETAILLIERTE BESCHREIBUNG DER ERFINDUNG

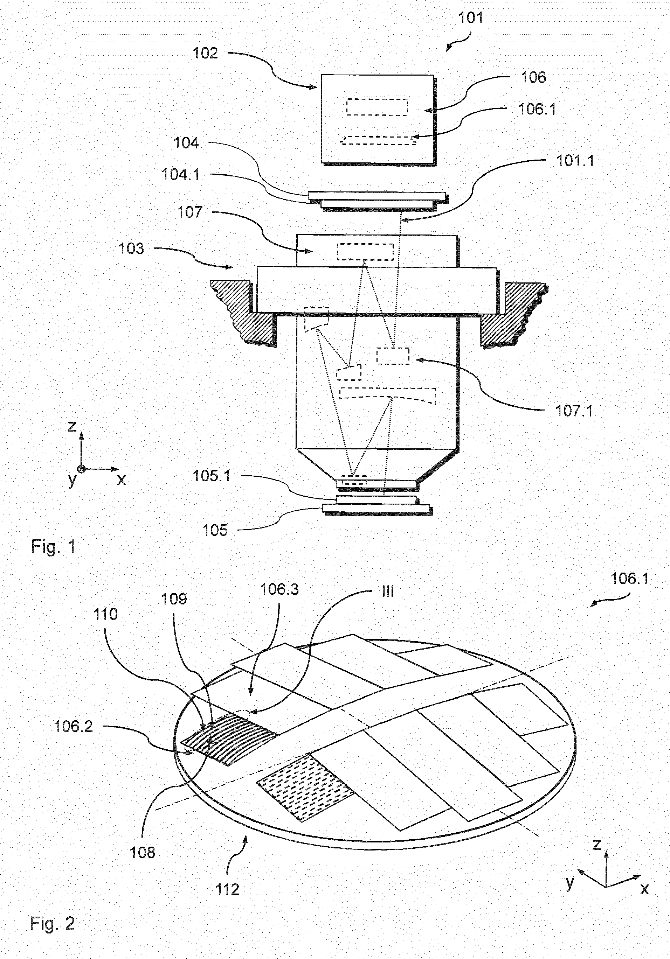

Im Folgenden wird unter Bezugnahme auf die Figuren 1 bis 6 ein bevorzugtes Ausführungsbeispiel einer erfindungsgemäßen Projektionsbelichtungsanlage 101 beschrieben, die ein bevorzugtes Ausführungsbeispiel eines erfindungsgemäßen optischen Moduls umfasst. Zur Vereinfachung der nachfolgenden Ausführungen wird in den Zeichnungen ein x,y,z-Koordinatensystem angegeben, wobei die z-Richtung der Richtung der Gravitationskraft entspricht. Selbstverständlich ist es in weiteren Ausgestaltungen möglich, beliebige davon abweichende Orientierungen eines x,y,z-Koordinatensystems zu wählen.

Figur 1 ist eine schematische, nicht maßstabsgetreue Darstellung der Projektionsbelichtungsanlage 101, die in einem Mikrolithographieprozess zur Herstellung von Halbleiterbauelementen verwendet wird. Die Projektionsbelichtungsanlage 101 umfasst eine Beleuchtungseinrichtung 102 und eine Projektionseinrichtung 103. Die Projektionseinrichtung 103 ist dazu ausgebildet, in einem Belichtungsprozess ein Bild einer Struktur einer Maske 104.1, die in einer Maskeneinheit 104 angeordnet ist, auf ein Substrat 105.1 zu übertragen, das in einer Substrateinheit 105 angeordnet ist. Dazu beleuchtet die Beleuchtungseinrichtung 102 die Maske 104.1. Die optische Projektionseinrichtung 103 empfängt das Licht von der Maske 104.1 und projiziert das Bild der Maskenstruktur der Maske 104.1 auf das Substrat 105.1, wie z.B. einen Wafer oder dergleichen.

Die Beleuchtungseinrichtung 102 umfasst eine optische Elementgruppe 106, die ein erfindungsgemäßes optisches Modul 106.1 aufweist. Wie im Folgenden näher ausgeführt wird, ist das optische Modul 106.1 in Form eines Feldfacettenspiegels ausgestaltet. Die Projektionseinrichtung 103 umfasst zudem eine optische Elementgruppe 107, die das optische Modul 107.1 aufweist. Die optischen Module 106.1, 107.1 der optischen Elementgruppen 106, 107 sind entlang einer gefalteten optischen Achse 101.1 der Projektionsbelichtungsanlage 101 angeordnet. Jede der optischen Elementgruppen 106, 107 kann eine Vielzahl optischer Module 106.1, 107.1 umfassen.

In dem vorliegenden Ausführungsbeispiel arbeitet die Projektionsbelichtungsanlage 101 mit Licht im EUV-Bereich (extrem ultraviolette Strahlung), mit Wellenlängen zwischen 5 nm bis 20 nm, insbesondere mit einer Wellenlänge von 13 nm. Bei den optischen Modulen 106.1, 107.1 der Beleuchtungseinrichtung 102 und der Projektionseinrichtung 103 handelt es sich daher ausschließlich um reflektive optische Elemente. In weiteren Ausgestaltungen der Erfindung ist es (insbesondere in Abhängigkeit von der Wellenlänge des Beleuchtungslichts) selbstverständlich auch möglich, jede Art von optischen Elementen (refraktiv, reflektiv, diffraktiv) alleine oder in beliebiger Kombination einzusetzen. Insbesondere können die Beleuchtungseinrichtung 102 und/oder die Projektionseinrichtung 103 eines oder mehrere erfindungsgemäße optische Module 106.1 umfassen.

Figur 2 zeigt ein Ausführungsbespiel eines erfindungsgemäßen optischen Moduls 106.1. Hierbei handelt es sich um einen Feldfacettenspiegel, der insbesondere im Zusammenwirken mit einem Pupillenfacettenspiegel zur Erzeugung sekundärer Lichtquellen in einem Beleuchtungsstrahlengang dient, um eine möglichst homogene Ausleuchtung der Maske 104.1 in den auszuleuchtenden Bereichen zu erzielen und insbesondere unterschiedliche Beleuchtungsverteilungen bzw. Beleuchtungssettings zu realisieren. Im vorliegenden Beispiel erfolgt der Lichteinfall auf den dargestellten Facettenspiegel 106.1 im Wesentlichen entlang der z-Richtung. Es kann jedoch auch eine beliebige andere, zur z-Richtung geneigte Beleuchtungsrichtung vorgesehen sein.

Der Facettenspiegel 106.1 gemäß Figur 2 umfasst eine Vielzahl optischer Elemente 108 bis 110, die als Feldfacettenelemente ausgebildet sind. An ihrer Oberseite, welche im Betrieb dem Lichteinfall zugewandt ist, weisen die Facettenelemente 108 bis 110 im vorliegenden Beispiel jeweils eine oder mehrere optisch wirksame Flächen in Form von Spiegelflächen 111 auf.

Die Facettenelemente 108 bis 110 des Facettenspiegels 106.1 sind im vorliegenden Beispiel in Facettengruppen 106.2 angeordnet. Die Facettengruppen 106.2 des Facettenspiegels 106.1 definieren dabei jeweils Referenzebenen 106.3 auf, die im vorliegenden Beispiel in unterschiedlichen Neigungswinkeln zu der durch die x- und y-Richtung aufgespannten Haupterstreckungsebene (xy Ebene) angeordnet sind. Die einzelnen Facettenelemente 108 bis 110 sind in Figur 2 lediglich für eine Facettengruppe 106.2 dargestellt. Die übrigen Facettengruppen 106.2 umfassen ebenfalls über die Erstreckung der jeweiligen Referenzebenen 106.3 angeordnete Facettenelemente 108 bis 110. Es versteht sich jedoch, dass bei anderen Varianten der Erfindung auch eine beliebige andere Anordnung und/oder Gruppierung der Facettenelemente gewählt sein kann

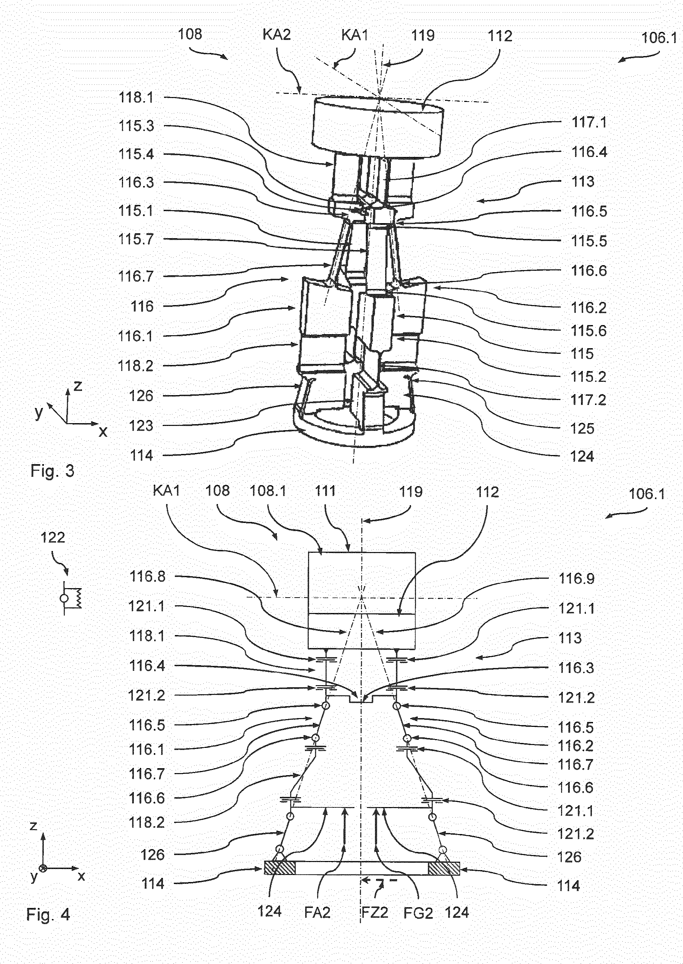

Figur 3 zeigt eine schematische perspektivische Ansicht eines Details des optischen Moduls 106.1 aus Figur 2, während die Figuren 4 bis 6 mechanische Ersatzschaltbilder für teils unterschiedliche Schnittansichten des optischen Moduls 106.1, teils in unterschiedlichen Betriebszuständen zeigen. Die Figuren 3 bis 5 zeigen das optische Modul dabei in einem ersten Betriebszustand. Hierbei handelt es sich um einen Ausgangszustand mit nicht ausgelenkter optischer Fläche 111. Sofern nichts anderes angegeben ist, beziehen sich die nachfolgenden Angaben zur Ausrichtung und Lage der einzelnen Komponenten auf diesen Ausgangszustand.

Wie insbesondere den Figuren 3 bis 5 zu entnehmen ist, umfasst das optische Modul 106.1 ein Facettenelement 108, dessen Facettenkörper 108.1 auf seiner dem Beleuchtungslicht abgewandten Seite mit einer Trägereinheit 112 verbunden ist, während an seiner dem Beleuchtungslicht zugewandten Seite die optische Fläche 111 ausgebildet ist. Es versteht sich jedoch, dass bei anderen Varianten auch vorgesehen sein kann, dass der Facettenkörper 108.1 monolithisch mit der Trägereinheit 112 ausgebildet ist.

Die Trägereinheit 112 ist durch eine Stützstruktur 113 abgestützt, die eine Basiseinheit 114, eine erste Stützeinheit 115 und eine von der ersten Stützeinheit 115 verschiedene zweite Stützeinheit 116 aufweist. Die Stützstruktur 113 ist als Parallelkinematik ausgebildet, indem die erste Stützeinheit 115 und die zweite Stützeinheit 116 zueinander kinematisch parallel zwischen der Basiseinheit 114 und der Trägereinheit 112 angeordnet sind.

Hierbei ist die erste Stützeinheit 115 zwischen der Basiseinheit 114 und der Trägereinheit 112 angeordnet und definiert eine erste Bewegungsebene BE1 und eine erste Kippachse KA1 der Trägereinheit 112, wobei die erste Kippachse KA1 senkrecht zu der ersten Bewegungsebene BE1 verläuft. Die Trägereinheit 112 ist dabei relativ zu der Basiseinheit 114 um die erste Kippachse KA1 verkippbar.

Die zweite Stützeinheit 116 ist ebenfalls zwischen der Basiseinheit 114 und der Trägereinheit 112 angeordnet. Dabei definiert sie eine zweite Bewegungsebene BE2 und eine zweite Kippachse KA2 der Trägereinheit 112, wobei die zweite Kippachse KA2 senkrecht zu der zweiten Bewegungsebene BE2 verläuft, die Trägereinheit 112 relativ zu der Basiseinheit 114 um die zweite Kippachse KA2 verkippbar ist.

Im vorliegenden Beispiel schneidet die zweite Kippachse KA2 die erste Kippachse KA1 und verläuft um 90° zu der ersten Kippachse KA1 geneigt. Es versteht sich jedoch, dass bei anderen Varianten auch eine anderweitige Gestaltung gewählt sein kann. Insbesondere können die beiden Kippachsen nicht in derselben Ebene liegen und/oder einander unter anderen Winkeln schneiden.

Die erste Stützeinheit 115 und die zweite Stützeinheit 116 sind jeweils nach Art eines Viergelenkgetriebes ausgebildet, das bei einer Auslenkung eine translatorische Bewegung der Trägereinheit 112 relativ zu der Basiseinheit 114 in der jeweiligen Bewegungsebene BE1 bzw. BE2 zulässt. Die erste Stützeinheit 115 und die zweite Stützeinheit 116 weisen jeweils zwei Entkopplungsabschnitte 117.1, 117.2 bzw. 118.1, 118.2 auf, welche die translatorische Bewegung in der Bewegungsebene BE2 bzw. BE1 der jeweils anderen Stützeinheit 116 bzw. 115 beim Verkippen der Trägereinheit 112 zulässt.

Die erste Stützeinheit 115 und die zweite Stützeinheit 116 schränken dabei aus sich heraus (d. h. ohne weitere zusätzliche Hilfseinrichtungen) einen Rotationsfreiheitsgrad um eine Rotationsachse ein, die senkrecht zu einer Ebene verläuft, die durch die erste Kippachse KA1 und die zweite Kippachse KA2 aufgespannt wird. Hiermit wird auf einfache Weise eine Verdrehung des Facettenelements 108 in der Ebene der optischen Fläche 111 verhindert, ohne dass zusätzliche Hilfseinrichtungen erforderlich wären.

Wie bereits ausgeführt wurde, können die Stützeinheiten 115, 116 beliebig gestaltet sein, um die gewünschte Parallelkinematik mit den Viergelenkgetrieben zu realisieren. Dabei können die beiden Stützeinheiten 115, 116 insbesondere eine voneinander abweichende Gestaltung vorgesehen sein.

Im vorliegenden Beispiel sind die erste Stützeinheit 115 und die zweite Stützeinheit 116 nahezu identisch jeweils nach Art eines Bipods ausgebildet, wobei sie einen ersten Schenkelabschnitt 115.1 bzw. 116.1 und einen zweiten Schenkelabschnitt 115.2 bzw. 116.2 aufweisen. Im vorliegenden Beispiel definieren beide Stützeinheiten 115 und 116 jeweils eine Bipodebene, die mit der zugehörigen Bewegungsebene BE1 bzw. BE2 zusammenfällt.

Wie insbesondere der Figur 3 zu entnehmen ist, sind die erste Stützeinheit 115 und die zweite Stützeinheit 116 derart ineinander verschachtelt angeordnet, dass eine Schnittlinie 119 der beiden Bewegungsebenen BE1 und BE2 jeweils zwischen den beiden Schenkelabschnitten 115.1 und 115.2 bzw. 116.1 und 116.2 liegt. Hierdurch ergibt sich eine besonders einfache und kompakte Gestaltung, wie sie insbesondere für den vorliegenden Facettenspiegel 106.1 mit einer Vielzahl dicht aneinander gepackter Facettenelemente 108-110 von Vorteil ist.

Wie ebenfalls den Figuren 3 bis 6 zu entnehmen ist, sind die erste Stützeinheit 115 und die zweite Stützeinheit 116 so angeordnet, dass sie um die Schnittlinie 119 der beiden Bewegungsebenen BE1 und BE2 um 90° zueinander verdreht sind. Bei diesem Verdrehwinkel von 90° ergibt sich eine besonders einfache Gestaltung mit klar definierten bzw. einfach auszulegenden mechanischen Eigenschaften der Stützstruktur 113. Insbesondere die dynamischen Eigenschaften lassen sich besonders einfach auslegen bzw. einstellen.

Durch die beschriebene um die Schnittlinie 119 verdrehte Anordnung wird zudem in einfacher Weise erreicht, dass die Freiheitsgrade quer zu Bewegungsebene BE1 bzw. BE2 der einen Stützeinheit 115 bzw. 116 durch die andere Stützeinheit 116 bzw. 115 eingeschränkt sind. Hiermit wird in einfacher Weise eine stabile Stützkonfiguration erzielt. Insbesondere wird hierdurch in einfacher Weise der Rotationsfreiheitsgrad um die Schnittlinie 119 eingeschränkt.

Wie bereits ausgeführt wurde, kann der Verdrehwinkel um die Schnittlinie 119 bei anderen Varianten auch anders gewählt sein. Besonders günstige und einfach zu realisierende Konfigurationen ergeben sich, wenn die beiden Stützeinheiten 115 und 116 zueinander um einen Winkel von 60° bis 90°, vorzugsweise 75° bis 90°, weiter vorzugsweise 80° bis 90°, verdreht angeordnet sind.

Wie bereits erwähnt, können die beiden Stützeinheiten 115 und 116 grundsätzlich voneinander verschieden gestaltet sein. Im vorliegenden Beispiel ist jedoch eine Konfiguration gewählt, die sich hinsichtlich ihrer mechanischen Eigenschaften besonders einfach auslegen lässt, indem die erste Stützeinheit 115 und die zweite Stützeinheit 116 im Wesentlichen identisch gestaltet sind. Der einzige Unterschied zwischen den beiden Stützeinheiten 115 und 116 besteht dabei in der Gestaltung des jeweiligen Brückenabschnitts 115.3 bzw. 116.3, welche die jeweiligen Schenkelabschnitte 115.1 und 115.2 bzw. 116.1 und 116.2 trägerseitig verbinden.

Wie insbesondere der Figur 3 zu entnehmen ist, sind die beiden Brückenabschnitte 115.3 und 116.3 komplementär zueinander gestaltet sein, um das Durchdringen der Bauräume der beiden Stützeinheiten 115 und 116 bei ihrer ineinander verschachtelten Anordnung zu realisieren. Die Brückenabschnitte 115.3 und 116.3 weisen hierzu jeweils eine Ausnehmung 115.4 bzw. 116.4 auf, durch welche der jeweils andere Brückenabschnitt 116.3 bzw. 115.3 hindurch verläuft. Dabei ist ausreichend Spiel vorgesehen, um in allen Betriebssituationen im Normalbetrieb einen Kontakt zwischen den beiden Brückenabschnitten 115.3 und 116.3 zu vermeiden.

Zur Ausgestaltung des Viergelenkgetriebes umfassen die erste Stützeinheit 115 und die zweite Stützeinheit 116 jeweils zwei voneinander beabstandete trägerseitige Gelenkabschnitte 115.5 bzw. 116.5 und zwei voneinander beabstandete basisseitige Gelenkabschnitte 115.6 bzw. 116.6.

Dabei definiert im vorliegenden Beispiel jeder der Gelenkabschnitte 115.5, 115.6, 116.5, 116.6, eine Gelenkachse für eine rotatorische Gelenkbewegung, die im Wesentlichen parallel zu der Kippachse KA1 bzw. KA2 der zugehörigen Stützeinheit 115 bzw. 116 ist. Die Gelenkabschnitte 115.5, 115.6, 116.5, 116.6 sind aber so angeordnet, dass für die Stützeinheiten 115 und 116 jeweils ein ebenes Viergelenkgetriebe ausgebildet ist. Im in den Figuren 3 bis 5 dargestellten ersten Betriebszustand bilden die Gelenkabschnitte 115.5, 115.6 bzw. 116.5, 116.6 jeweils die Eckpunkte eines Trapezes. Hierdurch ergibt sich eine besonders einfache und klar definierte Kinematik.

Die Gelenkabschnitte 115.5, 115.6 bzw. 116.5, 116.6 sind im vorliegenden Beispiel als Festkörpergelenke in Form von Biegegelenken ausgebildet, die jeweils einen Translationsfreiheitsgrad senkrecht zu der zugehörigen Bewegungsebene BE1 bzw. BE2 sowie einen Rotationsfreiheitsgrad um eine Rotationsachse einschränken, die in der zugehörigen Bewegungsebene BE1 bzw. BE2 liegt. Damit werden besonders einfache Gelenke realisiert, die in vorteilhafter Weise einen vergleichsweise großen Wärmedurchgangsquerschnitt besitzen.

Grundsätzlich könnten für die Gelenkabschnitte 115.5, 115.6 bzw. 116.5, 116.6 einfache Scharniergelenke verwendet werden. Im vorliegenden Beispiel werden die Gelenkabschnitte 115.5, 115.6 bzw. 116.5, 116.6 jeweils von einem Blattfederelement 115.7 bzw. 116.7 gebildet, wobei einer der trägerseitigen Gelenkabschnitte 115.5 bzw. 116.5 und einer der basisseitigen 115.6 bzw. 116.6 Gelenkabschnitte gemeinsam von einem Blattfederelement 115.7 bzw. 116.7 gebildet sind. Hierdurch ergibt sich eine besonders einfache Gestaltung, bei der die beiden Gelenkabschnitte 115.5, 115.6 bzw. 116.5, 116.6 in guter Näherung an den beiden Enden des Blattfederelements 115.7 bzw. 116.7 angenommen werden können.

Im vorliegenden Beispiel verläuft ein durch das jeweilige Blattfederelement 115.7 bzw. 116.7 gebildete Schenkelteil des ersten Schenkelabschnitts 115.1 bzw. 116.1 zwischen einem ersten basisseitigen Gelenkabschnitt 115.6 bzw. 116.6 und einem in Kraftflussrichtung nächstliegenden ersten trägerseitigen Gelenkabschnitt 115.5 bzw. 116.5, wobei dieser Schenkelteil in der zugehörigen Bewegungsebene BE1 bzw. BE2 eine erste Schenkellängsachse 115.8 bzw. 116.8 definiert, während wenigstens ein Schenkelteil des zweiten Schenkelabschnitts 115.2 bzw. 116.2 zwischen einem zweiten trägerseitigen Gelenkabschnitt 115.5 bzw. 116.5 und einem in Kraftflussrichtung nächstliegenden zweiten basisseitigen Gelenkabschnitt 115.6 bzw. 116.6 verläuft und in der zugehörigen Bewegungsebene BE1 bzw. BE2 eine zweite Schenkellängsachse 115.9 bzw. 116.9 definiert.

Durch die Schenkellängsachsen 115.8, 115.9 bzw. 116.8, 116.9 ist im vorliegenden Beispiel der oben beschriebene Verlauf der jeweiligen Kippachse KA1 bzw. KA2 definiert. So verlaufen die erste Schenkellängsachse 115.8 bzw. 116.8 und die zweite Schenkellängsachse 115.9 bzw. 116.9 jeweils zueinander geneigt, wobei sie einander jeweils in der zugehörigen Kippachse KA1 bzw. KA2 ihrer Stützeinheit 115 bzw. 116. schneiden.

Die Abstände zwischen den trägerseitigen Gelenksabschnitten 115.5 bzw. 116.5 und den basisseitigen Gelenkabschnitten 115.6 bzw. 116.6 sind entsprechend der Lage der zugehörigen Kippachse KA1 bzw. KA2 gewählt. Im vorliegenden Beispiel ist daher in der zugehörigen Bewegungsebene BE1 bzw. BE2 ein Abstand der beiden trägerseitigen Gelenkabschnitte 115.5 bzw. 116.5 geringer ist als ein Abstand der beiden basisseitigen Gelenkabschnitte 115.6 bzw. 116.6. Hierdurch wird erreicht, dass die zugehörige Kippachse KA1 bzw. KA2 jeweils trägerseitig des Viergelenkgetriebes angeordnet ist, wobei die beiden Kippachsen KA1 bzw. KA2 im vorliegenden Beispiel in einer gemeinsamen Ebene liegen.

Das Verkippen der optischen Fläche 111 um die beiden Kippachsen KA1 bzw. KA2 wird nachfolgend am Beispiel der ersten Stützeinheit 115 und der ersten Kippachse KA1 mit Bezug auf die Figuren 3, 5 und 6 beschrieben. Es sei jedoch ausdrücklich erwähnt, dass nicht zuletzt aufgrund der weit gehend identischen Gestaltung der Stützeinheiten 115 und 116 das Verkippen der optischen Fläche 111 um die Kippachse KA2 in identischer Weise erfolgt.

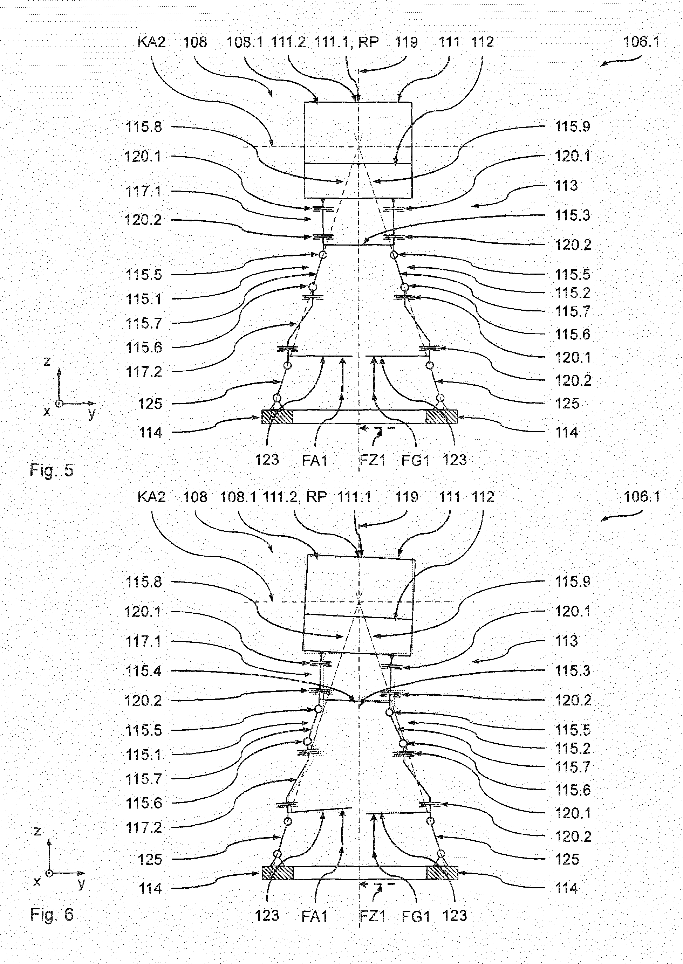

Figur 6 zeigt dabei einen zweiten Betriebszustand, in dem die optische Fläche 111 gegenüber dem ersten Betriebszustand aus Figur 5 um die ersten Kippachse KA1 verkippt ist. Wie aus den Figuren 5 und 6 ersichtlich wird, ist die Kippachse KA1 auf einer der Basiseinheit 114 zugewandten Seite der optischen Fläche 111 angeordnet. Hiermit ist es möglich, durch geeignete Wahl der Abstände zwischen der optischen Fläche 111 und der Kippachse KA1 eine Kompensation für die Translation der optischen Fläche in der Bewegungsebene BE1 zu erzielen, welche beim Verkippen in der Bewegungsebene BE1 mittels des Viergelenkgetriebes stattfindet.

Hierbei weist die optische Fläche 111 in der zugehörigen Bewegungsebene BE1 eine Flächennormale FN1 auf, welche durch die Kippachse KA1 verläuft. Ein erster Flächenpunkt 111.1 der optischen Fläche 111 weist auf dieser Flächennormalen FN1 einen Kippachsenabstand KAA1 zu der Kippachse KA1 auf. In ersten Betriebszustand (Figur 5) befindet sich erste Flächenpunkt 111.1 in einer Referenzposition RP zu der Basiseinheit 114.

Wie der Figur 6 zu entnehmen ist, ist der Kippachsenabstand KAA1 derart gewählt, dass sich ein zweiter Flächenpunkt 111.2 der optischen Fläche 111 in dem in Figur 6 dargestellten zweiten Betriebszustand (in dem die optische Fläche 111 gegenüber dem ersten Betriebszustand um die Kippachse KA1 verkippt ist) an der Referenzposition RP befindet.

Mit anderen Worten wird hierdurch eine Konfiguration erzielt, bei der die durch das Viergelenkgetriebe der ersten Stützeinheit 115 bedingte Translationsbewegung der optischen Fläche 111 während des Verkippens um die Kippachse KA1 kompensiert wird, sodass das Licht an der Referenzposition RP in beiden Betriebszuständen jeweils auf die optische Fläche 111 trifft. Im vorliegenden Beispiel ist die optische Fläche 111 eine Planfläche, sodass in den beiden Betriebszuständen unterschiedliche Einfallswinkel des Lichts auf die optische Fläche 111 realisiert werden. Gegebenenfalls kann in Spezialfällen aber auch vorgesehen sein, dass die optische Fläche 111 so gestaltet ist, dass der Einfallswinkel des Lichts in den beiden Betriebszuständen im Wesentlichen derselbe ist.

Die in der einen Stützeinheit 115 bzw. 116 realisierte Entkopplung der translatorischen Bewegung in der Bewegungsebene BE2 bzw. BE1 der anderen Stützeinheit 116 bzw. 115 wird im vorliegenden Beispiel dadurch realisiert, dass die beiden Entkopplungsabschnitte 117.1, 117.2 bzw. 118.1, 118.2 zu beiden Seiten der Blattfederelemente 115.7 bzw. 116.7 angeordnet sind, welche den das Viergelenkgetriebe ausbildenden Viergelenkgetriebeabschnitt der jeweiligen Stützeinheiten 115 bzw. 116 bilden.

Die beiden Entkopplungsabschnitte 117.1, 117.2 bzw. 118.1, 118.2 sind dabei kinematisch seriell zwischen dem Viergelenkgetriebeabschnitt 115.7 bzw. 116.7 und der Basiseinheit 114 bzw. der Trägereinheit 112 angeordnet. Dabei ist der Viergelenkgetriebeabschnitt 115.7 bzw. 116.7 jeweils kinematisch seriell zwischen dem ersten Entkopplungsabschnitt 117.1 bzw. 118.1 und dem zweiten Entkopplungsabschnitt 117.2 bzw. 118.2 angeordnet. Hierdurch ergibt sich eine besonders einfache Konfiguration mit klar verteilten Rollen hinsichtlich der Kinematik der unterschiedlichen Abschnitte.

Es versteht sich jedoch, dass bei anderen Varianten gegebenenfalls auch mein einziger solcher Entkopplungsabschnitt vorgesehen sein kann. Gegebenenfalls kann also einer der beiden Entkopplungsabschnitte 117.1, 117.2 bzw. 118.1, 118.2 auch fehlen. Weiterhin kann ein solcher Entkopplungsabschnitt innerhalb des Viergelenkgetriebeabschnitts 115.7 bzw. 116.7 integriert werden, beispielsweise kinematisch seriell zwischen den basisseitigen Gelenkabschnitten 115.6 bzw. 116.6 und den trägerseitigen Gelenkabschnitten 115.5 bzw. 116.5.

Im vorliegenden Beispiel weist der jeweilige Entkopplungsabschnitt 117.1, 117.2 bzw. 118.1, 118.2 der beiden Stützeinheiten 115 bzw. 116 einen ersten Enkopplungsgelenkabschnitt 120.1 bzw. 121.1 auf, der eine erste Enkopplungsschwenkachse ESA1 definiert, und einen zweiten Enkopplungsgelenkabschnitt 120.2 bzw. 121.2 auf, der eine zweite Enkopplungsschwenkachse ESA2 definiert, die zu der ersten Enkopplungsschwenkachse ESA1 beabstandet und parallel ist. Hierdurch ist eine besonders einfache Entkopplung von Translationsbewegungen in der Bewegungsebene BE2 bzw. BE1 der anderen Stützeinheiten 116 bzw. 115 möglich. Dabei gestaltet sich die Kinematik besonders einfach, da die beiden Enkopplungsschwenkachsen ESA1 und ESA2 parallel zu der Bewegungsebene BE1 bzw. BE2 der jeweiligen Stützeinheit 115 bzw. 116 verlaufen.

Wie schon bei dem Viergelenkgetriebe können auch die Gelenke 120.1, 120.2, 121.1, 121.2 des jeweiligen Entkopplungsabschnitts 117.1, 117.2 bzw. 118.1, 118.2 auf beliebige geeignete Weise gestaltet sein, wobei insbesondere die oben angestellten Überlegungen zu den Gelenkabschnitten auch hier zutreffen. Die Enkopplungsgelenkabschnitte 120.1, 120.2, 121.1, 121.2 sind im vorliegenden Beispiel daher als Festkörpergelenke in Form von Biegegelenken ausgebildet, die jeweils einen Translationsfreiheitsgrad in der zugehörigen Bewegungsebene BE1 bzw. BE2 sowie einen Rotationsfreiheitsgrad um eine Rotationsachse einschränken, die in der zugehörigen Bewegungsebene BE1 bzw. BE2 liegt. Damit werden wiederum besonders einfache Gelenke realisiert, die in vorteilhafter Weise einen vergleichsweise großen Wärmedurchgangsquerschnitt besitzen.

Grundsätzlich könnten für die Enkopplungsgelenkabschnitte 120.1, 120.2, 121.1, 121.2 einfache Scharniergelenke verwendet werden. Im vorliegenden Beispiel werden die Gelenkabschnitte 120.1, 120.2, bzw. 121.1, 121.2 wiederum jeweils von einem Blattfederelement 117.1, 117.2 bzw. 118.1, 118.2 gebildet, wobei jeweils zwei in Kraftflussrichtung unmittelbar aneinandergrenzende Gelenkabschnitte 120.1, 120.2, bzw. 121.1, 121.2 gemeinsam von einem Blattfederelement 117.1, 117.2 bzw. 118.1, 118.2 gebildet sind. Hierdurch ergibt sich eine besonders einfache Gestaltung, bei der die beiden Gelenkabschnitte 120.1, 120.2, bzw. 121.1, 121.2 in guter Näherung an den beiden Enden des Blattfederelements 117.1, 117.2 bzw. 118.1, 118.2 angenommen werden können. Hiermit lassen sich auch im Bereich der Entkopplungsabschnitte die oben im Zusammenhang mit den Gelenkabschnitten des Viergelenkgetriebes geschilderten Vorteile erzielen.

Sei an dieser Stelle erwähnt, dass alle im vorliegenden Beispiel verwendeten Festkörpergelenke ihrer Auslenkung (aus einem unbelasteten Zustand) einen gewissen elastischen Widerstand entgegensetzen, wie dies in Figur 4 durch das Ersatzschaltbild 122 angedeutet ist.

Wie bereits ausgeführt wurde, kann die Verstellung der optischen Fläche 111 auf vielfältige Weise realisiert sein. Dabei können grundsätzlich sowohl passive als auch aktive Verstellmechanismen realisiert werden.

Im vorliegenden Beispiel wirkt die Verstelleinrichtung mit den Stützeinheiten 115 bzw. 116 zusammen. Hierzu ist ein Aktuatorelement 123 bzw. 124 zum Verkippen der Trägereinheit 112 um die jeweilige Kippachse KA1 bzw. KA2 vorgesehen, das einen Aktuatorabschnitt des jeweiligen Schenkelabschnitts 115.1 115.2 bzw. 116.1, 116.2 bildet und als solches direkt mit der jeweiligen Stützeinheit 115 bzw. 116 verbunden ist. Der Aktuatorabschnitt 123 bzw. 124 ist dabei kinematisch seriell zu dem Viergelenkgetriebeabschnitt 115.7 bzw. 116.7 zwischen der Basiseinheit 114 und der Trägereinheit 112 angeordnet ist. Genauer gesagt ist der Aktuatorabschnitt 123 bzw. 124 im vorliegenden Beispiel kinematisch seriell zwischen der Basiseinheit 114 und dem jeweiligen Viergelenkgetriebeabschnitt 115.7 bzw. 116.7 angeordnet.

Auf das Aktuatorelement 123 bzw. 124 des jeweiligen ersten Schenkelabschnitts 115.1 bzw. 116.1 wirkt jeweils ein Aktuator, der in den Figuren 4 bis 6 jeweils durch seine Aktuatorkraft FA1 bzw. FA2 dargestellt ist. Hierbei kann es sich um einen beliebigen geeigneten Aktuator handeln, der die Aktuatorkraft FA1 bzw. FA2 erzeugt und sich im vorliegenden Beispiel gegen die Basiseinheit 114 oder eine damit verbundene Struktur abstützt.

Auf das Aktuatorelement 123 bzw. 124 des jeweiligen zweiten Schenkelabschnitts 115.2 bzw. 116.2 wirkt jeweils ein Gegenaktuator, der in den Figuren 4 bis 6 jeweils durch seine Aktuatorkraft FG1 bzw. FG2 dargestellt ist. Hierbei kann es sich wiederum um einen beliebigen geeigneten Aktuator handeln, der die Gegenaktuatorkraft FG1 bzw. FG2 erzeugt und sich im vorliegenden Beispiel gegen die Basiseinheit 114 oder eine damit verbundene Struktur abstützt.

Die Aktuatorkraft FA1 bzw. FA2 kann dabei durch eine entsprechende aktive Einrichtung erzeugt werden, während die Gegenaktuatorkraft FG1 bzw. FG2 durch eine einfache passive Einrichtung, beispielsweise eine Feder oder dergleichen zur Verfügung gestellt wird. Es versteht sich jedoch, dass auch die Gegenaktuatorkraft FG1 bzw. FG2 durch eine entsprechende aktive Einrichtung erzeugt werden kann. Ebenso kann eine solche Gegenaktuatorkraft FG1 bzw. FG2 auch vollständig fehlen bzw. ausschließlich durch die elastischen Gegenkräfte der jeweiligen Gelenkabschnitte der Stützeinheit 115 bzw. 116 zur Verfügung gestellt sein.

Es versteht sich jedoch, dass bei weiteren Varianten auch vorgesehen sein kann, dass der Aktuator sich an der Trägereinheit 112 oder an einer anderen gelenkig verbundenen Komponente der jeweiligen Stützeinheit 115 bzw. 116 abstützen kann.

Das jeweilige Aktuatorelement 123 bzw. 124 wirkt mit dem zugeordneten Aktuator (FA1 bzw. FA2) zusammen, um den von ihm gebildeten Aktuatorabschnitt 123 bzw. 124 in der Bewegungsebene BE1 bzw. BE2 der zugehörigen Stützeinheit 115 bzw. 116 zu verschwenken. Hierzu ist der jeweilige Aktuatorabschnitt 123 bzw. 124 über eine Verbindungsgelenkeinheit 125 bzw. 126 mit der Basiseinheit 114 verbunden. Die jeweilige Verbindungsgelenkeinheit 125 bzw. 126 definiert im vorliegenden Beispiel eine Verbindungsschwenkachse VSA1 bzw. VSA2, die senkrecht zu der Bewegungsebene BE1 bzw. BE2 der zugehörigen Stützeinheit 115 bzw. 116 verläuft.

Die Verbindungsgelenkeinheit 125 bzw. 126 ist im vorliegenden Beispiel wiederum ein Festkörpergelenk in Form eines als Biegegelenk wirkenden Blattfederelements, welches ähnlich zu den oben bereits beschriebenen Gelenkabschnitten des Viergelenkgetriebes 115.7 bzw. 116.7 gestaltet ist. Dabei liegt die Längsachse des Blattfederelements 125 bzw. 126 auf der jeweiligen Schenkellängsachse 115.8, 115.9 bzw. 116.8, 116.9, so dass sich eine unter dynamischen Gesichtspunkten günstige Konfiguration ergibt.

Im vorliegenden Beispiel wirkt die jeweilige Aktuatorkraft FA1 bzw. FA2 bzw. die jeweilige Gegenaktuatorkraft FG1 bzw. FG2 im Wesentlichen parallel zu der Schnittlinie 119. Hierdurch ergibt sich eine besonders einfache und kompakte Gestaltung. Es versteht sich jedoch, dass bei anderen Varianten der Erfindung auch eine beliebige andere Ausrichtung der Aktuatorkraft FA1 bzw. FA2 bzw. die jeweilige Gegenaktuatorkraft FG1 bzw. FG2 in der jeweiligen Bewegungsebene BE1 bzw. BE2 gegeben sein kann, um das erforderliche Moment um die Verbindungsschwenkachse VSA1 bzw. VSA2 zu erzeugen. Weiterhin versteht es sich, dass die jeweiligen Aktuatorelemente 123 bzw. 124 auch ineinander verschachtelt gestaltet sein können, um den Hebelarm für die jeweilige Aktuatorkraft FA1 bzw. FA2 bzw. die jeweilige Gegenaktuatorkraft FG1 bzw. FG2 entsprechend zu verlängern.

Es versteht sich weiterhin, dass bei anderen Varianten auch ein zentrales Aktuatorelement in Form eines zentralen Kipphebels vorgesehen sein kann, der direkt mit der Trägereinheit 112 verbunden ist, sich entlang der Schnittlinie 112 erstreckt und an seinem basisseitigen Ende mit einer zentralen Aktuatorkraft FZ1 bzw. FZ2 eines zentralen Aktuators beaufschlagt wird, wie dies in den Figuren 4 und 5 angedeutet ist. Dieses zentrale Aktuatorelement würde kinematisch parallel zu den beiden Stützeinheiten 115, 116 zwischen der Trägereinheit 112 und dem mit der Basiseinheit 114 verbundenen Aktuator wirken.

Die jeweilige Stützeinheit 115 bzw. 116 kann grundsätzlich auf beliebige geeignete Weise gestaltet sein. Insbesondere kann sie aus mehreren separat gefertigten Komponenten zusammengesetzt sein. Im vorliegenden Beispiel sind die erste Stützeinheit 115 und die zweite Stützeinheit 116 jedoch monolithisch ausgebildet und monolithisch mit der Trägereinheit 112 und der Basiseinheit 114 verbunden, da dies unter dynamischen und thermischen Aspekten besonders günstig ist.

Es sei an dieser Stelle nochmals erwähnt, dass sich die vorliegende Erfindung grundsätzlich für ein einzelnes optisches Element 108 mit einer einzelnen optischen Fläche 111 verwenden lässt.

Im vorliegenden Beispiel sind jedoch alle Facettenelemente 108 bis 110 des Facettenspiegels 106.1 über eine derartige Stützstruktur 113 mit derartigen Stützeinheiten 115 bzw. 116 abgestützt. Es versteht sich jedoch, dass gegebenenfalls auch nur einzelne der Facettenelemente 108 bis 110 auf diese Weise abgestützt sein können.

Die vorliegende Erfindung wurde vorstehend ausschließlich anhand eines Beispiels aus dem Bereich der Mikrolithographie beschrieben. Es versteht sich jedoch, dass die Erfindung auch im Zusammenhang mit beliebigen anderen optischen Anwendungen, insbesondere Abbildungsverfahren bei anderen Wellenlängen, zum Einsatz kommen kann.

Weiterhin kann die Erfindung im Zusammenhang mit der Inspektion von Objekten, wie beispielsweise der so genannten Maskeninspektion zu Einsatz kommen, bei welcher die für die Mikrolithographie verwendeten Masken auf ihre Integrität etc. untersucht werden. An Stelle des Substrats 105.1 tritt dann in Figur 1 beispielsweise eine Sensoreinheit, welche die Abbildung des Projektionsmusters der Maske 104.1 (zur weiteren Verarbeitung) erfasst. Diese Maskeninspektion kann dann sowohl im Wesentlichen bei derselben Wellenlänge erfolgen, die im späteren Mikrolithographieprozess verwendet wird. Ebenso können aber auch beliebige hiervon abweichende Wellenlängen für die Inspektion verwendet werden.

Die vorliegende Erfindung wurde vorstehend schließlich anhand eines konkreten Ausführungsbeispiels beschrieben, welches konkrete Kombinationen der in den nachfolgenden Patentansprüchen definierten Merkmale zeigt. Es sei an dieser Stelle ausdrücklich darauf hingewiesen, dass der Gegenstand der vorliegenden Erfindung nicht auf diese Merkmalskombinationen beschränkt ist, sondern auch sämtliche übrigen Merkmalskombinationen, wie sie sich aus den nachfolgenden Patentansprüchen ergeben, zum Gegenstand der vorliegenden Erfindung gehören.

## Patentansprüche

1. Optisches Modul, insbesondere Facettenspiegel, mit
- einer Trägereinheit (112) für eine optische Fläche und
- einer Stützstruktur (113), wobei
- die Trägereinheit (112) durch die Stützstruktur (113) abgestützt ist,
- die Stützstruktur (113) eine Basiseinheit (114), eine erste Stützeinheit und eine von der ersten Stützeinheit (115) verschiedene zweite Stützeinheit (116) aufweist,
- die erste Stützeinheit (115) zwischen der Basiseinheit (114) und der Trägereinheit (112) angeordnet ist und eine erste Bewegungsebene und eine erste Kippachse der Trägereinheit (112) definiert,
- die erste Kippachse senkrecht zu der ersten Bewegungsebene verläuft,
- die Trägereinheit (112) relativ zu der Basiseinheit (114) um die erste Kippachse verkippbar ist,
- die zweite Stützeinheit (116) zwischen der Basiseinheit (114) und der Trägereinheit (112) angeordnet ist und eine zweite Bewegungsebene und eine zweite Kippachse der Trägereinheit (112) definiert,
- die zweite Kippachse senkrecht zu der zweiten Bewegungsebene verläuft,
- die Trägereinheit (112) relativ zu der Basiseinheit (114) um die zweite Kippachse verkippbar ist und
- die zweite Kippachse zu der ersten Kippachse geneigt verläuft,
**dadurch gekennzeichnet, dass**
- die erste Stützeinheit (115) und die zweite Stützeinheit (116) zueinander kinematisch parallel zwischen der Basiseinheit (114) und der Trägereinheit (112) angeordnet sind,
- die erste Stützeinheit (115) und die zweite Stützeinheit (116) jeweils nach Art eines Viergelenkgetriebes ausgebildet sind, das eine translatorische Bewegung der Trägereinheit (112) relativ zu der Basiseinheit (114) in der jeweiligen Bewegungsebene zulässt,
- die erste Stützeinheit (115) und die zweite Stützeinheit (116) jeweils wenigstens einen Entkopplungsabschnitt aufweisen, der die translatorische Bewegung in der Bewegungsebene der jeweils anderen Stützeinheit (116, 115) zulässt.

2. Optisches Modul nach Anspruch 1, wobei
- die erste Stützeinheit (115) und die zweite Stützeinheit (116) jeweils nach Art eines Bipods mit einem ersten Schenkelabschnitt (115.1, 116.1) und einem zweiten Schenkelabschnitt (115.2, 116.2) ausgebildet sind,
wobei
- insbesondere wenigstens eine der beiden Stützeinheiten eine Bipodebene definiert, die mit der zugehörigen Bewegungsebene zusammenfällt,
und/oder
- die erste Stützeinheit (115) und die zweite Stützeinheit (116) insbesondere derart ineinander verschachtelt angeordnet sind, dass eine Schnittlinie (119) der beiden Bewegungsebenen jeweils zwischen den beiden Schenkelabschnitten (115.1, 115.2, 116.1, 116.2) liegt,
und/oder
- die erste Stützeinheit (115) und die zweite Stützeinheit (116) insbesondere derart angeordnet sind, dass sie um eine Schnittlinie (119) der beiden Bewegungsebenen zueinander verdreht angeordnet sind, insbesondere um einen Winkel von 60° bis 90°, vorzugsweise 75° bis 90°, weiter vorzugsweise 80° bis 90°, zueinander verdreht angeordnet sind,
und/oder
- die erste Stützeinheit (115) und die zweite Stützeinheit (116) insbesondere im Wesentlichen identisch gestaltet sind, insbesondere mit Ausnahme eines die jeweiligen Schenkelabschnitte (115.1, 115.2, 116.1, 116.2) trägerseitig verbindenden Brückenabschnitts identisch gestaltet sind,
und/oder
- die erste Stützeinheit (115) und die zweite Stützeinheit (116) insbesondere derart gestaltet ist, dass sie einen Rotationsfreiheitsgrad um eine Rotationsachse einschränken, die senkrecht zu einer Ebene verläuft, die durch die erste Kippachse und die zweite Kippachse aufgespannt wird oder parallel zu der ersten Kippachse und der zweiten Kippachse verläuft.

3. Optisches Modul nach Anspruch 1 oder 2, wobei
- die erste Stützeinheit (115) und die zweite Stützeinheit (116) jeweils zwei voneinander beabstandete trägerseitige Gelenkabschnitte und zwei voneinander beabstandete basisseitige Gelenkabschnitte aufweist,
wobei
- insbesondere wenigstens einer der Gelenkabschnitte, vorzugsweise jeder der Gelenkabschnitte, eine Gelenkachse für eine rotatorische Gelenkbewegung definiert, wobei die Gelenkachse zumindest im Wesentlichen parallel zu der Kippachse der zugehörigen Stützeinheit (115, 116) ist,
und/oder
- die Gelenkabschnitte wenigstens einer der beiden Stützeinheiten (115, 116) insbesondere derart angeordnet und ausgebildet sind, dass ein ebenes Viergelenkgetriebe ausgebildet ist.
und/oder
- die Gelenkabschnitte wenigstens einer der beiden Stützeinheiten (115, 116) insbesondere derart angeordnet und ausgebildet sind, dass sie in einem Betriebszustand die Eckpunkte eines Trapezes bilden.

4. Optisches Modul nach Anspruch 3, wobei
- wenigstens einer der Gelenkabschnitte, vorzugsweise jeder der Gelenkabschnitte, einen Rotationsfreiheitsgrad um eine Rotationsachse einschränkt, die in der zugehörigen Bewegungsebene liegt,
und/oder
- wenigstens einer der Gelenkabschnitte, vorzugsweise jeder der Gelenkabschnitte, als Festkörpergelenk ausgebildet ist,
und/oder
- wenigstens einer der Gelenkabschnitte, vorzugsweise jeder der Gelenkabschnitte, als Biegegelenk ausgebildet ist,
und/oder
- wenigstens einer der Gelenkabschnitte, vorzugsweise jeder der Gelenkabschnitte, von einem Blattfederelement gebildet ist,
und/oder
- wenigstens einer der trägerseitigen Gelenkabschnitte und einer der basisseitigen Gelenkabschnitte gemeinsam von einem Blattfederelement gebildet sind.

5. Optisches Modul nach Anspruch 3 oder 4, wobei
- wenigstens eine der beiden Stützeinheiten (115, 116) einen ersten Schenkelabschnitt (115.1, 116.1) und einen zweiten Schenkelabschnitt (115.2, 116.2) aufweist, wobei
- wenigstens ein Schenkelteil des ersten Schenkelabschnitts (115.1, 116.1) zwischen einem ersten basisseitigen Gelenkabschnitt und einem in Kraftflussrichtung nächstliegenden ersten trägerseitigen Gelenkabschnitt verläuft und in der zugehörigen Bewegungsebene eine erste Schenkellängsachse definiert,
- wenigstens ein Schenkelteil des zweiten Schenkelabschnitts (115.2, 116.2) zwischen einem zweiten trägerseitigen Gelenkabschnitt und einem in Kraftflussrichtung nächstliegenden zweiten basisseitigen Gelenkabschnitt verläuft und in der zugehörigen Bewegungsebene eine zweite Schenkellängsachse definiert,
wobei
- die erste Schenkellängsachse und die zweite Schenkellängsachse insbesondere zueinander geneigt verlaufen
und/oder
- die erste Schenkellängsachse und die zweite Schenkellängsachse einander insbesondere in der zugehörigen Kippachse schneiden
und/oder
- in der zugehörigen Bewegungsebene insbesondere ein Abstand der beiden trägerseitigen Gelenkabschnitte geringer ist als ein Abstand der beiden basisseitigen Gelenkabschnitte
und/oder
- insbesondere wenigstens einer der beiden Schenkelteile ein Blattfederelement umfasst, insbesondere von einem Blattfederelement gebildet ist.

6. Optisches Modul nach einem der Ansprüche 1 bis 5, wobei
- wenigstens eine der beiden Kippachsen auf einer der Basiseinheit (114) zugewandten Seite der optischen Fläche angeordnet ist,
wobei insbesondere
- die optische Fläche in der zugehörigen Bewegungsebene eine Flächennormale aufweist, welche durch die wenigstens eine Kippachse verläuft und ein erster Flächenpunkt der optischen Fläche auf der Flächennormalen einen Kippachsenabstand zu der wenigstens einen Kippachse aufweist,
- der erste Flächenpunkt sich in einem ersten Betriebszustand in einer Referenzposition zu der Basiseinheit (114) befindet und
- der Kippachsenabstand derart gewählt ist, dass sich ein zweiter Flächenpunkt der optischen Fläche in einem zweiten Betriebszustand an der Referenzposition befindet, wobei die optische Fläche in dem zweiten Betriebszustand gegenüber dem ersten Betriebszustand um die wenigstens eine Kippachse verkippt ist.

7. Optisches Modul nach einem der Ansprüche 1 bis 6, wobei
- die erste Stützeinheit (115) und die zweite Stützeinheit (116) jeweils einen das Viergelenkgetriebe ausbildenden Viergelenkgetriebeabschnitt aufweisen,
wobei
- der wenigstens eine Entkopplungsabschnitt wenigstens einer der beiden Stützeinheiten (115, 116) insbesondere kinematisch seriell zwischen dem Viergelenkgetriebeabschnitt und der Basiseinheit (114) oder der Trägereinheit (112) angeordnet ist,
und/oder
- wenigstens eine der beiden Stützeinheiten (115, 116) insbesondere einen ersten Entkopplungsabschnitt und einen zweiten Entkopplungsabschnitt aufweist, wobei der Viergelenkgetriebeabschnitt kinematisch seriell zwischen dem ersten Entkopplungsabschnitt und dem zweiten Entkopplungsabschnitt angeordnet ist,
und/oder
- der wenigstens eine Entkopplungsabschnitt wenigstens einer der beiden Stützeinheit (115) insbesondere einen ersten Enkopplungsgelenkabschnitt aufweist, der eine erste Enkopplungsschwenkachse definiert, und einen zweiten Enkopplungsgelenkabschnitt aufweist, der eine zweite Enkopplungsschwenkachse definiert, die zu der ersten Enkopplungsschwenkachse beabstandet und parallel ist, wobei die beiden Enkopplungsschwenkachsen insbesondere parallel zu der Bewegungsebene der wenigstens einen Stützeinheit verlaufen.

8. Optisches Modul nach Anspruch 7, wobei
- der wenigstens eine Entkopplungsabschnitt, vorzugsweise jeder Entkopplungsabschnitt, ein Festkörpergelenk umfasst,
und/oder
- der wenigstens eine Entkopplungsabschnitt, vorzugsweise jeder Entkopplungsabschnitt, ein Biegegelenk umfasst,
und/oder
- der wenigstens eine Entkopplungsabschnitt, vorzugsweise jeder Entkopplungsabschnitt, von einem Blattfederelement gebildet ist.

9. Optisches Modul nach einem der Ansprüche 1 bis 8, wobei
- wenigstens ein Aktuatorelement zum Verkippen der Trägereinheit (112) um wenigstens eine der beiden Kippachsen vorgesehen ist,
wobei
- das wenigstens eine Aktuatorelement direkt mit der Trägereinheit (112) verbunden ist und dazu ausgebildet ist, kinematisch parallel zu der ersten Stützeinheit (115) und der zweiten Stützeinheit (116) zwischen der Trägereinheit (112) und einer mit der Basiseinheit (114) verbundenen aktiven Aktuatoreinheit zu wirken, wobei das Aktuatorelement insbesondere eine Längsachse definiert, die zumindest in einem Betriebszustand im Wesentlichen parallel, insbesondere im Wesentlichen kollinear, zu einer Schnittlinie (119) der beiden Bewegungsebenen verläuft,
und/oder
- das wenigstens eine Aktuatorelement direkt mit einer der beiden Stützeinheiten (115, 116) verbunden ist und dazu ausgebildet ist, mit einer aktiven Aktuatoreinheit zusammenzuwirken, die innerhalb der Stützeinheit (115, 116) oder zwischen der Stützeinheit (115, 116) und der Basiseinheit (114) oder zwischen der Stützeinheit (115, 116) und der Trägereinheit (112) wirkt.

10. Optisches Modul nach Anspruch 9, wobei
- die erste Stützeinheit (115) und/oder die zweite Stützeinheit (116) nach Art eines Bipods ausgebildet ist, das einen ersten Schenkelabschnitt (115.1, 116.1) und einen zweiten Schenkelabschnitt (115.2, 116.2) umfasst, die einen das Viergelenkgetriebe ausbildenden Viergelenkgetriebeabschnitt aufweisen,
- das wenigstens eine Aktuatorelement direkt mit einem Aktuatorabschnitt eines der beiden Schenkelabschnitte (115.1, 115.2, 116.1, 116.2) verbunden ist und
- der Aktuatorabschnitt kinematisch seriell zu dem Viergelenkgetriebeabschnitt zwischen der Basiseinheit (114) und der Trägereinheit (112) angeordnet ist,
wobei
- das Aktuatorelement insbesondere dazu ausgebildet ist, mit der aktiven Aktuatoreinheit zusammenzuwirken, um den Aktuatorabschnitt in der Bewegungsebene der zugehörigen Stützeinheit zu verschwenken,
und/oder
- der Aktuatorabschnitt insbesondere über eine Verbindungsgelenkeinheit mit der Basiseinheit (114) oder der Trägereinheit (112) verbunden ist, wobei die Verbindungsgelenkeinheit eine Verbindungsschwenkachse definiert, die quer, insbesondere senkrecht, zu der Bewegungsebene der zugehörigen Stützeinheit (115, 116) verläuft, wobei die Verbindungsgelenkeinheit insbesondere wenigstens ein Blattfederelement umfasst.

11. Optisches Modul nach einem der Ansprüche 1 bis 10, wobei
- die erste Stützeinheit (115) und/oder die zweite Stützeinheit (116) zumindest abschnittsweise monolithisch ausgebildet ist
und/oder
- die erste Stützeinheit (115) und/oder die zweite Stützeinheit (116) nach Art eines Bipods ausgebildet ist, das einen ersten Schenkelabschnitt (115.1, 116.1) und einen zweiten Schenkelabschnitt (115.2, 116.2) umfasst, die einen das Viergelenkgetriebe ausbildenden Viergelenkgetriebeabschnitt aufweisen, wobei der erste Schenkelabschnitt (115.1, 116.1) und/oder der zweite Schenkelabschnitt (115.2, 116.2) monolithisch ausgebildet ist, insbesondere Viergelenkgetriebeabschnitt monolithisch ausgebildet ist und/oder insbesondere der erste Schenkelabschnitt (115.1, 116.1) monolithisch mit dem zweiten Schenkelabschnitt (115.2, 116.2) ausgebildet ist,
und/oder
- die erste Stützeinheit (115) und/oder die zweite Stützeinheit (116) monolithisch mit der Trägereinheit (112) und/oder der Basiseinheit (114) verbunden ist.

12. Optisches Modul nach einem der Ansprüche 1 bis 11, wobei
- die Trägereinheit (112) ein optisches Element, insbesondere ein Facettenelement, trägt, an dem die optische Fläche ausgebildet ist,
und/oder
- die erste Stützeinheit (115), die zweite Stützeinheit (116) und die Trägereinheit (112) ein Teilmodul bilden und eine Mehrzahl dieser Teilmodule vorgesehen ist, wobei insbesondere jedes Teilmodul eine eigene Basiseinheit (114) umfasst, die mit einer Basisstruktur verbunden ist, oder eine gemeinsame Basiseinheit (114) für die Teilmodule vorgesehen ist.

13. Optische Abbildungseinrichtung, insbesondere für die Mikrolithographie, mit
- einer Beleuchtungseinrichtung (102) mit einer ersten optischen Elementgruppe (106),
- einer Objekteinrichtung (104) zur Aufnahme eines Objekts (104.1),
- einer Projektionseinrichtung (103) mit einer zweiten optischen Elementgruppe (107) und
- einer Bildeinrichtung (105), wobei
- die Beleuchtungseinrichtung (102) zur Beleuchtung des Objekts (104.1) ausgebildet ist und
- die Projektionseinrichtung (103) zur Projektion einer Abbildung des Objekts (103.1) auf die Bildeinrichtung (105) ausgebildet ist,
**dadurch gekennzeichnet, dass**
- die Beleuchtungseinrichtung (102) und/oder die Projektionseinrichtung (103) wenigstens ein optisches Modul (106.1) nach einem der Ansprüche 1 bis 15 umfasst.

14. Verfahren zum Abstützen einer Trägereinheit für eine optische Fläche eines optischen Moduls, insbesondere eines Facettenspiegels, bei dem
- die Trägereinheit (112) durch die Stützstruktur (113) abgestützt wird, die Stützstruktur (113) eine Basiseinheit (114), eine erste Stützeinheit (115) und eine von der ersten Stützeinheit (115) verschiedene zweite Stützeinheit (116) aufweist, wobei
- die erste Stützeinheit (115) zwischen der Basiseinheit (114) und der Trägereinheit (112) angeordnet wird und eine erste Bewegungsebene und eine erste Kippachse der Trägereinheit (112) definiert, wobei die erste Kippachse senkrecht zu der ersten Bewegungsebene verläuft und die Trägereinheit (112) relativ zu der Basiseinheit (114) um die erste Kippachse verkippbar ist,
- die zweite Stützeinheit (116) zwischen der Basiseinheit (114) und der Trägereinheit (112) angeordnet wird und eine zweite Bewegungsebene und eine zweite Kippachse der Trägereinheit (112) definiert, wobei die zweite Kippachse senkrecht zu der zweiten Bewegungsebene verläuft, die Trägereinheit (112) relativ zu der Basiseinheit (114) um die zweite Kippachse verkippbar ist und die zweite Kippachse zu der ersten Kippachse geneigt verläuft,
**dadurch gekennzeichnet, dass**
- die erste Stützeinheit (115) und die zweite Stützeinheit (116) zueinander kinematisch parallel zwischen der Basiseinheit (114) und der Trägereinheit (112) angeordnet werden,
- die erste Stützeinheit (115) und die zweite Stützeinheit (116) jeweils nach Art eines Viergelenkgetriebes ausgebildet werden, das eine translatorische Bewegung der Trägereinheit (112) relativ zu der Basiseinheit (114) in der jeweiligen Bewegungsebene zulässt,
- die erste Stützeinheit (115) und die zweite Stützeinheit (116) jeweils mit wenigstens einen Entkopplungsabschnitt versehen werden, der die translatorische Bewegung in der Bewegungsebene der jeweils anderen Stützeinheit zulässt.

15. Optisches Abbildungsverfahren, insbesondere für die Mikrolithographie, bei dem
- über eine Beleuchtungseinrichtung (102) mit einer ersten optischen Elementgruppe (106) ein Objekt (104.1) beleuchtet wird und
- mittels einer Projektionseinrichtung (103) mit einer zweiten optischen Elementgruppe (107) eine Abbildung des Objekts (104.1) auf einer Bildeinrichtung (105) erzeugt wird, **dadurch gekennzeichnet, dass**
- in der Beleuchtungseinrichtung (102) und/der Projektionseinrichtung (103), insbesondere während des Erzeugens der Abbildung, ein Verfahren nach Anspruch 14 verwendet wird.
